(19) Europäisches Patentamt / European Patent Office / Office européen des brevets

(11) **EP 4 542 652 A1**

(12) **EUROPEAN PATENT APPLICATION**
published in accordance with Art. 153(4) EPC

(43) Date of publication:
23.04.2025 Bulletin 2025/17

(21) Application number: 22952414.5

(22) Date of filing: 28.07.2022

(51) International Patent Classification (IPC):
*H01L 27/15* (2006.01)   *H10K 59/00* (2023.01)

(52) Cooperative Patent Classification (CPC):
H10H 29/10; H10K 59/00

(86) International application number:
PCT/CN2022/108729

(87) International publication number:
WO 2024/020956 (01.02.2024 Gazette 2024/05)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicants:
• Boe Technology Group Co., Ltd.
Beijing 100015 (CN)
• Chengdu BOE Optoelectronics Technology Co.,
Ltd.
Chengdu, Sichuan 611731 (CN)

(72) Inventors:
• JIANG, Zhiliang
Beijing 100176 (CN)
• ZHANG, Tiaomei
Beijing 100176 (CN)
• WANG, Mengqi
Beijing 100176 (CN)

(74) Representative: Potter Clarkson
Chapel Quarter
Mount Street
Nottingham NG1 6HQ (GB)

(54) **DISPLAY PANEL AND DISPLAY DEVICE**

(57)   A display panel and a display device, relating to the technical field of display. A display area of the display panel comprises a main display area and secondary display areas; a driving back plate comprised in the display panel comprises a substrate, a plurality of pixel circuits, and a first power bus connected to second electrodes, and one first electrode is connected to one pixel circuit. The driving back plate comprises the substrate and a plurality of circuit units; each circuit unit comprises two pixel circuits distributed in the row direction; light-emitting devices comprise first electrodes, light-emitting layers, and the second electrodes; one first electrode is connected to one pixel circuit; each line set comprises two data lines distributed in the row direction; two data lines in one line set are respectively connected to two columns of pixel circuits of one column of circuit units; data lines comprise a plurality of first data lines and a plurality of second data lines; the first data lines extend from the main display area to a lead-out area; the second data lines are located in the secondary display areas; power lines extend from the display area to the lead-out area in the column direction; two columns of pixel circuits of one column of circuit units are connected to one power line.

FIG.21

## Description

## TECHNICAL FIELD

The present disclosure relates to the field of display technologies, and in particular to a display panel and a display device.

## BACKGROUND

Organic Light Emitting Diode (OLED) display panels have advantages such as self-luminescence, wide color gamut, high contrast, flexibility, high response and flexibility, and have broad application prospects. However, power consumption of current display panels is relatively large.

It should be noted that the information disclosed in the Background section above is only for enhancing the understanding of the background of the present disclosure, and thus may include information that does not constitute prior art known to those of ordinary skill in the art.

## SUMMARY

The present disclosure provides a display panel and a display device.

According to an aspect of the present disclosure, there is provided a display panel, including a display area and a peripheral area outside the display area, wherein the peripheral area includes a lead-out area extended in a direction away from the display area, the lead-out area has a binding portion, and the display area and the lead-out area are distributed in a column direction; and the display area includes a main display area and secondary display areas disposed on both sides of the main display area in a row direction;

the display panel includes a driving backplane and a plurality of light emitting devices disposed on a side of the driving backplane, the driving backplane includes a substrate and a plurality of circuit units located on a side of the substrate, the circuit unit includes two pixel circuits distributed along the row direction, and the two pixel circuits of the same circuit unit are symmetrically disposed;
the light emitting device includes a first electrode, a light emitting layer and a second electrode stacked in a direction away from the driving backplane, wherein a first electrode is coupled to a pixel circuit;
the driving backplane includes:

a first power bus, disposed in the peripheral area and coupled to the second electrode;
a plurality of data lines, extended along the column direction and divided into a plurality of line groups distributed along the row direction, wherein each of the line groups includes two data lines distributed along the row direction; the two data lines of one line group are respectively coupled to two columns of pixel circuits of one column of circuit units; individual data lines includes a plurality of first data lines and a plurality of second data lines; the first data lines are extended from the main display area to the lead-out area and are coupled to the binding portion; and the second data lines are located in the secondary display area;
a plurality of power lines, extended from the display area to the lead-out area along the column direction, wherein the two columns of pixel circuits of one column of circuit units are coupled to a power line;
a plurality of first connection lines, extended along the row direction, wherein at least part of the first connection lines includes first transfer lines and first dummy lines disposed at intervals; and the first transfer lines are extended from the secondary display area to the main display area;
a plurality of second connection lines, extended along the column direction, wherein a second connection line is located between two adjacent line groups, and data lines of the two adjacent line groups are symmetrically disposed about the second connection line between the two line groups; at least part of the second connection lines includes second transfer lines and second dummy lines disposed at intervals; and the second transfer lines are extended from the main display area to the lead-out area and are coupled to the binding portion;
a first transfer line and a second transfer line are coupled to form a transfer line; and a second data line is coupled to the binding portion at least through a transfer line; and
the first connection line is insulated from the data line, and at least part of the first dummy lines and at least part of the second dummy lines are coupled, and are coupled to the first power bus.

In an embodiment of the present disclosure, the first transfer lines and the first dummy lines are disposed in the same layer on a side of the power line close to the substrate, and the second transfer line and the second dummy line are disposed in the same layer and on a side of the first connection lines away from the substrate;

a first transfer line and a first dummy line adjacent to each other in the same first connection line are disposed at an interval through a gap, and a second transfer line and a second dummy line adjacent to each other in the same second connection line are disposed at an interval through a gap; and
at least part of the gaps of the first connection lines is overlapped with the second connection line or the power line.

In an embodiment of the present disclosure, the first connection line is located on a side of the data line close to the substrate.

In an embodiment of the present disclosure, at least part of the gaps is overlapped with a part of the first electrode.

In an embodiment of the present disclosure, the display panel further includes:
a touch layer, disposed on a side of the light emitting device away from the substrate and including a touch electrode layer, wherein the touch electrode layer is a mesh structure surrounded by a plurality of channel lines, and at least part of gaps is overlapped with a part of channel lines.

In an embodiment of the present disclosure, the gap of the first connection line is a first gap, and the gap of the second connection line is a second gap;

a part of first gaps is overlapped with the second connection lines, and the other part of the first gaps is overlapped with the power lines; and
the second gap is overlapped with the first electrode or the channel line.

In an embodiment of the present disclosure, a part of the first transfer lines is continuously extended along the row direction to the peripheral area, and a part of the second transfer lines is continuously extended along the column direction to the lead-out area.

In an embodiment of the present disclosure, the second connection line is disposed in the same layer as the data line and the power line, and is located on a side of the first connection line away from the substrate;

the driving backplane further includes first transfer portions distributed in an array and second transfer portions distributed in an array, wherein the first transfer portions, the second transfer portions and the first connection line are disposed in the same layer;
a column of first transfer portions is overlapped with a data line, and the data line is coupled to respective pixel circuits of a column of pixel circuits through respective first transfer portions overlapped with the data line, respectively; and a first transfer line is coupled to a second data line through a first transfer portion; and
a column of second transfer portions is overlapped with a second connection line, and a second transfer line is coupled to a first transfer line through a second transfer portion.

In an embodiment of the present disclosure, at least part of second dummy lines is coupled to at least part of first dummy lines through at least part of second transfer portions.

In an embodiment of the present disclosure, the first transfer portion is coupled to the data line through a first contact hole, and the second transfer portion is coupled to the second connection line through a second contact hole;

individual first contact holes and individual second contact holes are divided into a plurality of hole groups distributed in an array, and a column of hole groups is located between power lines coupled to two adjacent circuit units; and
one of the hole groups includes two of the first contact holes and one of the second contact holes, and the two first contact holes are symmetrically disposed with respect to the second contact hole.

In an embodiment of the present disclosure, the two first contact holes and one second contact hole in the same hole group are distributed in a triangle.

In an embodiment of the present disclosure, the driving backplane further includes first electrode transfer portions distributed in an array and second electrode transfer portions distributed in an array, the first electrode transfer portions are disposed in the same layer as the first transfer portion and the second transfer portion, the second electrode transfer portions are located on a side of the first electrode transfer portions away from the substrate, and a first electrode transfer portion and a second electrode transfer portion are overlapped and coupled through a third contact hole; the first electrode is coupled to the pixel circuit through the second electrode transfer portion, the third contact hole and the first electrode transfer portion; and the hole group further includes the third contact hole; and
in the same hole group, the first contact hole is coupled to a pixel circuit in a n+1th row, and the third contact hole is coupled to a pixel circuit in a nth row; and two third contact holes are located on both sides of the second contact hole and distributed along the column direction.

In an embodiment of the present disclosure, the pixel circuit includes a driving transistor, a writing transistor, a compensation transistor, a first reset transistor, a second reset transistor, a third reset transistor, a first light emitting control transistor, a second light emitting control transistor and a storage capacitor; the driving backplane further includes a first reset control line, a first reset signal line, a second reset control line, a second reset signal line, a third reset signal line, a first scan line, a second scan line and a light emitting control line;

a gate of the driving transistor is coupled to the first node, a first electrode of the driving transistor is coupled to a power line through the first light emitting control transistor, and a second electrode of the driving transistor is coupled to a first electrode of a light emitting device through the second light emitting control transistor; and gates of the first light emitting control transistor and the second light emitting control transistor are coupled to the light emitting control line;

a gate of the first reset transistor is coupled to the first reset control line, a first electrode of the first reset transistor is coupled to the first reset signal line, and a second electrode of the first reset transistor is coupled to the first node;

a gate of the writing transistor is coupled to the first scan line, a first electrode of the writing transistor is coupled to a data line, and a second electrode of the writing transistor is coupled to the first electrode of the driving transistor;

a gate of the compensation transistor is coupled to the second scan line, a first electrode of the compensation transistor is coupled to the second electrode of the driving transistor, and a second electrode of the compensation transistor is coupled to the first node;

a gate of the second reset transistor is coupled to the second reset control line, a first electrode of the second reset transistor is coupled to the second reset signal line, and a second electrode of the second reset transistor is coupled to the first electrode;

a gate of the third reset transistor is coupled to the second reset control line, a first electrode of the third reset transistor is coupled to the third reset signal line, and a second electrode of the third reset transistor is coupled to the first electrode of the driving transistor;

a first electrode plate of the storage capacitor is coupled to the power line, and a second electrode plate of the storage capacitor is coupled to the first node; and

the first reset transistor and the compensation transistor are metal oxide transistors; and the driving transistor, the writing transistor, the second reset transistor, the third reset transistor, the first light emitting control transistor and the second light emitting control transistor are polycrystalline silicon transistors.

In an embodiment of the present disclosure, the driving backplane further includes:

a first semiconductor layer, disposed on a side of the substrate, and including channels of the driving transistor, the writing transistor, the second reset transistor, the third reset transistor, the first light emitting control transistor, and the second light emitting control transistor;

a first gate insulation layer, by which the first semiconductor layer is covered;

a first gate layer, disposed on a surface of the first gate insulation layer away from the substrate and overlapped with at least part of the first semiconductor layer, wherein the first gate layer includes the second reset control line, the light emitting control line, the first scan line and the first electrode plate;

a first insulation layer, by which the first gate layer is covered;

a second gate layer, disposed on a surface of the first insulation layer away from the substrate, and including the second electrode plate overlapped with the first electrode plate;

a second insulation layer, by which the second gate layer is covered;

a second semiconductor layer, disposed on a surface of the second insulation layer away from the substrate, and including channels of the first reset transistor and the compensation transistor;

a second gate insulation layer, by which the second semiconductor layer is covered;

a third gate layer, disposed on a surface of the third gate insulation layer away from the substrate and overlapped with at least part of the second semiconductor layer, wherein the third gate layer includes the first reset control line, the first reset signal line, the second scan line and at least part of the third reset signal line;

a third insulation layer, by which the third gate layer is covered;

a first source-drain layer, disposed on a surface of the third insulation layer away from the substrate, and including the second reset signal line and at least part of the third reset signal line;

a first planar layer, disposed on a side of the first source-drain layer away from the substrate;

a second source-drain layer, disposed on a surface of the first planar layer away from the substrate, and including the first connection line;

a second planar layer, by which the second source-drain layer is covered;

a third source-drain layer, disposed on a surface of the second planar layer away from the substrate and including the data line, the power line and the second connection line; and

a third planar layer, by which the third source-drain layer is covered, wherein the first electrode is disposed on a surface of the third planar layer away from the substrate.

In an embodiment of the present disclosure, the second semiconductor layer includes an oxide active portion extended along the column direction, the oxide active portion is located between the first reset signal line and the third reset signal line; the first reset control line is overlapped with the oxide active portion to form the first reset transistor, and the second reset control line is overlapped with the oxide active portion to form the compensation transistor;

the first source-drain layer includes a first connection portion, an end of the first connection portion is coupled to the first electrode plate, and the other end is coupled to the oxide active portion between channels of the first reset transistor and the second reset control line; and

the driving backplane further includes a plurality of shielding portions located on the second source-drain layer, and a shielding portion is overlapped with a first connection portion of a pixel circuit and a channel of the compensation transistor, and is coupled to a power line coupled to the pixel circuit.

In an embodiment of the present disclosure, in a circuit unit where a shielding portion and a first connection portion overlapped with the shielding portion are located, two second electrode panels of a pixel circuit of the circuit unit are overlapped with and coupled to the shielding portion.

In an embodiment of the present disclosure, the first source-drain layer includes a second connection portion and a third connection portion, the second connection portion is coupled to two second electrode plates; and a third connection portion is coupled to a second electrode plate and a first electrode of the first light emitting control transistor.

In an embodiment of the present disclosure, in a circuit unit where a shielding portion and a first connection portion overlapped with the shielding portion are located, two data lines coupled to the circuit unit are located on both sides of the shielding portion, and a power line coupled to the circuit unit is located between the two data lines and is overlapped with and coupled to the shielding portion.

In an embodiment of the present disclosure, in a power line and a circuit unit coupled thereto, the power line has protrusions protruded toward both sides along the row direction, and the two protrusions are overlapped with channels of first reset transistors of two pixel circuits, respectively.

In an embodiment of the present disclosure, a first reset control line, a first reset signal line, a second reset control line, a second reset signal line, a third reset signal line, a first scan line, a second scan line and a light emitting control line coupled to pixel circuits in the same row are all extended along the row direction and are distributed along the column direction;

the first reset control line, the first scan line, the second scan line, the third reset signal line, the light emitting control line and the second reset control line are located between the first reset signal line and the second reset signal line; the first scan line, the second scan line, at least part of the third reset signal line and the light emitting control line are located between the first reset control line and the second reset control line; the second scan line is located between the first scan line and the light emitting control line; the second electrode plate is located between the second scan line and at least part of the third reset signal line; and the light emitting control line is overlapped with the at least part of the third reset signal line; and
a first reset signal line coupled to pixel circuits in a n+1th row is overlapped with a second reset control line coupled to pixel circuits in a n-th row.

In an embodiment of the present disclosure, a second reset signal line coupled to the pixel circuits in the n+1th row is overlapped with both the first scan line and a first reset control line coupled to the pixel circuits in the n-th row.

In an embodiment of the present disclosure, the third reset signal line includes a line body extended along the row direction and a line branch coupled to a side of the line body close to the second reset signal line, the line body and the line branch are located in different layers; the line body is located between the second scan line and the second reset control line, and is overlapped with the light emitting control line; and the line branch is extended between the second reset control line and the second reset signal line, and is coupled to the first electrode of the third reset transistor.

In an embodiment of the present disclosure, the line body is located in the third gate layer, and the line branch is located in the first source-drain layer.

In an embodiment of the present disclosure, a first reset signal line is overlapped with a first connection line.

In an embodiment of the present disclosure, the oxide active portion has a capacitor portion extended along the row direction, and the capacitor portion is coupled between channels of the first reset transistor and the compensation transistor; and the capacitor portion is overlapped with the first scan line and is coupled to the first connection portion.

In an embodiment of the present disclosure, the second gate layer further includes an auxiliary control line and an auxiliary scan line extended along the row direction, the auxiliary control line is overlapped with and is coupled to the first reset control line, and the auxiliary scan line is overlapped with and is coupled to the second scan line.

According to an aspect of the present disclosure, there is provided a display device, including any one of the display panels described above.

It should be noted that the above general description and the following detailed description are merely exemplary and explanatory and should not be construed as limiting of the disclosure.

## BRIEF DESCRIPTION OF THE DRAWINGS

The drawings herein are incorporated in and constitute a part of the specification, illustrate embodiments consistent with the present disclosure, and together with the description serve to explain principles of the present disclosure. Apparently, the drawings in the following description are only some embodiments of the present disclosure. For those of ordinary skilled in the art, other drawings may be obtained based on these drawings without paying any creative effort.

FIG. 1 is a top view of an embodiment of a display panel of the present disclosure.

FIG. 2 is a data line distribution diagram of an embodiment of a display panel of the present disclosure.

FIG. 3 is a schematic cross-sectional view of an embodiment of a display panel of the present disclosure.

FIG. 4 is a schematic diagram of a pixel circuit in an embodiment of a display panel of the present disclosure.

FIG. 5 is a top view of a circuit unit in an embodiment of a display panel of the present disclosure.

FIG. 6 is a schematic diagram of a first semiconductor layer and a first gate layer in FIG. 5.

FIG. 7 is a schematic diagram of a first semiconductor layer to a second gate layer in FIG. 5.

FIG. 8 is a schematic diagram of a first semiconductor layer to an oxide semiconductor layer in FIG. 5.

FIG. 9 is a schematic diagram of a first semiconductor layer to a third gate layer in FIG. 5.

FIG. 10 is a schematic diagram of a first semiconductor layer to a first source-drain layer in FIG. 5.

FIG. 11 is a schematic diagram of a first semiconductor layer to a second source-drain layer in FIG. 5.

FIGS. 12 to 20 are respectively partial schematic diagrams of some film layers of a driving backplane in an embodiment of a display panel of the present disclosure.

FIG. 21 is a partial top view of a second source-drain layer and a third source-drain layer in an embodiment of a display panel of the present disclosure.

FIG. 22 is a partial top view of a second source-drain layer in an embodiment of a display panel of the present disclosure.

FIG. 23 is a partial top view of a third source-drain layer in an embodiment of a display panel of the present disclosure.

FIG. 24 is a partial top view of a shielding layer in another embodiment of a display panel of the present disclosure.

FIG. 25 is a partial top view of a third source-drain layer and a first electrode in an embodiment of a display panel of the present disclosure.

FIG. 26 is a partial top view of a third source-drain layer and a touch electrode layer in an embodiment of a display panel of the present disclosure.

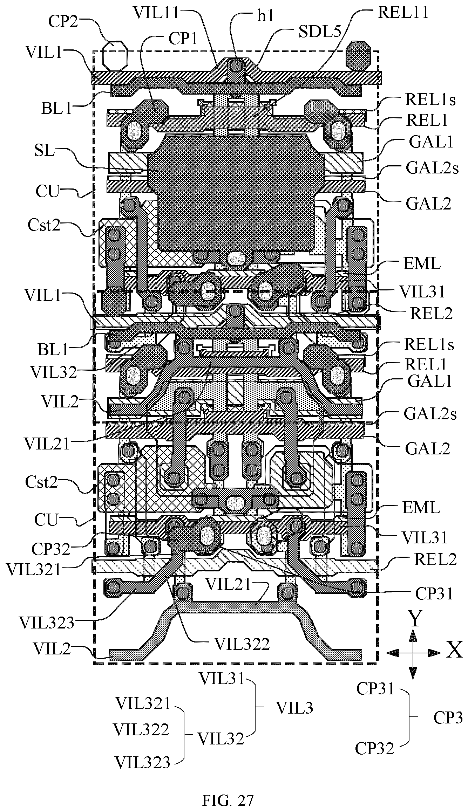

FIG. 27 is a partial top view of a column of circuit units in an embodiment of a display panel of the present disclosure.

## DETAILED DESCRIPTION

Example embodiments will now be described more fully with reference to the accompanying drawings. However, the example embodiments can be implemented in a variety of forms and should not be construed as being limited to examples set forth herein; rather, these embodiments are provided so that the present disclosure will be more complete and comprehensive so as to convey the idea of the example embodiments to those skilled in this art. The same reference numerals in the drawings denote the same or similar structures, and the repeated description thereof will be omitted. In addition, the drawings are merely schematic representations of the present disclosure and are not necessarily drawn to scale.

The terms "one", "a", "the", "said", and "at least one" are used to indicate that there are one or more elements/components or the like; the terms "include" and "have" are used to indicate an open meaning of including and means that there may be additional elements/components/etc. in addition to the listed elements/components/etc.; the terms "first", "second" and "third" etc. are used only as markers, and do not limit the number of objects.

A row direction X and a column direction Y herein are merely two directions perpendicular to each other. In the drawings of the present disclosure, the row direction X may be horizontal and the column direction Y may be vertical, but this is not limited thereto. If a display panel is rotated, actual orientations of the row direction X and the column direction Y may change.

Feature A and feature B "overlapping" herein means that an orthographic projection of feature A on a substrate and an orthographic projection of feature B on the substrate at least partially overlap.

Feature A and feature B being "in the same layer" herein means that feature A and feature B can be formed at the same time, which are different discontinuous or continuous areas in the same film layer, and are not separated by other film layers in a direction perpendicular to the substrate. "Different layers" means that feature A and feature B are distributed at intervals in the direction perpendicular to the substrate, which are separated by other film layers.

Features A being "adjacent" herein means that there are no other A features between them.

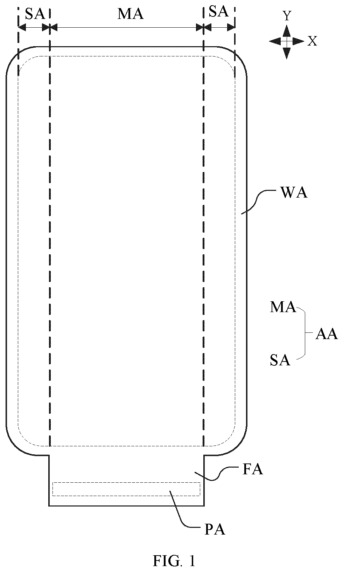

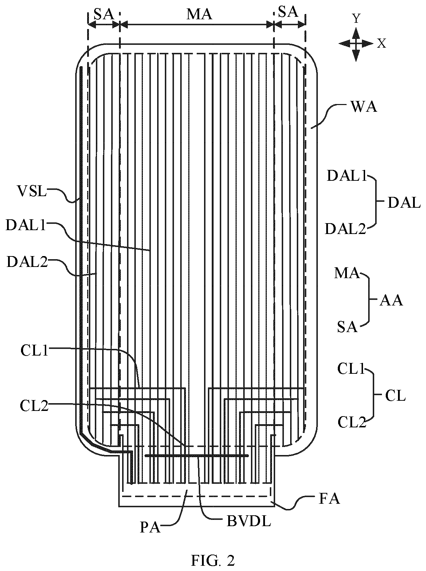

Embodiments of the present disclosure provide a display panel. As shown in FIGS. 1 and 2, the display panel may have a display area AA and a peripheral area WA located outside the display area AA. The peripheral area WA may be a continuous or discontinuous annular area surrounding the display area AA, and a shape of the peripheral area WA is not particularly limited herein.

The peripheral area WA may include a lead-out area FA extending in a direction away from the display area AA, and the display area AA and the lead-out area FA may be distributed along a column direction Y. The lead-out area FA has a binding portion PA, and the binding portion PA may be provided with a plurality of pads, through which the flexible circuit board may be bound, so that the display area AA of the display panel may be controlled to emit light by a control circuit board bound to the flexible circuit board, so as to display an image.

The display area AA may include a main display area MA and secondary display areas SA disposed on both sides of the main display area MA along a row direction X, that is, there are two secondary display areas SA, which are separated on both sides of the display area MA. For example, the display area AA may be in a shape of quadrilateral, four corners of the quadrilateral are rounded corners, and a width of the secondary display area SA in the row direction X is not greater than a width of the rounded corner in the row direction X.

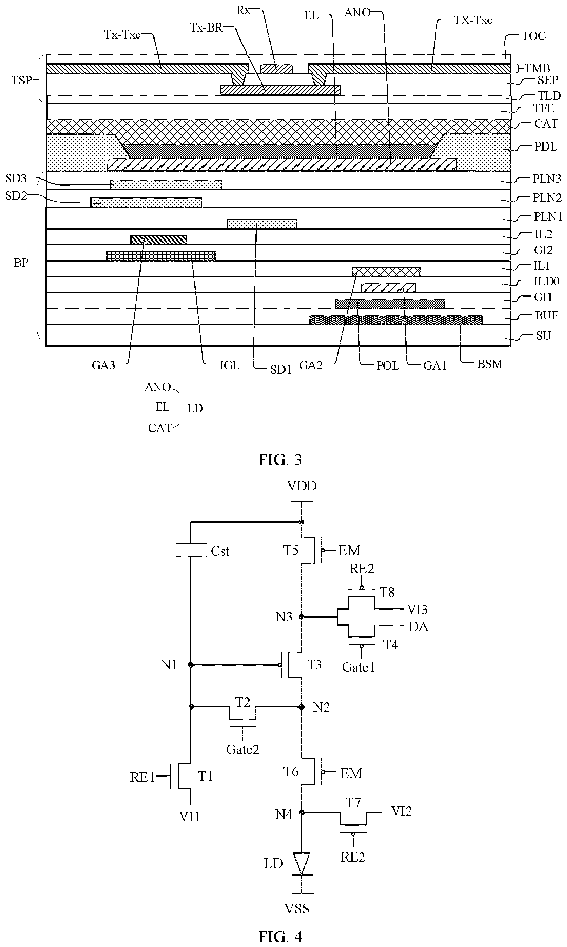

As shown in FIG. 3, the display panel may include a driving backplane BP and a plurality of light emitting devices LD, and the driving backplane BP has a driving circuit. Each light emitting device LD may be disposed on a side of the driving backplane BP and located in the display area AA, and the main display area MA and the secondary display area SA are both provided with light emitting devices LD, and the light emitting device LD may include a first electrode ANO, a light emitting layer EL and a second electrode CAT stacked in a direction away from the driving backplane BP. The light emitting device LD may be an organic light emitting diode (OLED). Alternatively, the light emitting device LD may also be a Micro LED and a Mini LED, or may also be a light emitting device such as a QLED.

As shown in FIG. 3, the first electrode ANO may be disposed on a side of the driving backplane BP, and the light emitting layer EL may include a hole injection layer, a hole transport layer, a light emitting material layer, an electron transport layer, and an electron injection layer stacked in the direction away from the driving backplane BP. Individual light emitting devices LD may share the second electrode CAT, that is, the second electrode CAT may be a continuous whole-layer structure, and the second electrode CAT may extend to the peripheral area and may receive a first power signal VSS. The first electrodes ANO are distributed in an array to ensure that individual light emitting devices LD can emit light independently. In addition, in order to limit a light emitting range of the light emitting device LD and prevent crosstalk, a pixel definition layer PDL may be disposed on a surface where the first electrode ANO is disposed, and the pixel definition layer PDL may be provided with an opening exposing each first electrode ANO, and the light emitting layer EL is stacked with the first electrode ANO in the opening.

Individual light emitting devices LD may at least share a light emitting material layer, so that light emitting colors of the individual light emitting devices LD are the same. In this case, in order to achieve color display, a color filter layer may be disposed on a side of the light emitting device LD away from the substrate SU, and the color display is achieved through filter portions corresponding to respective light emitting devices LD in the color filter layer. Alternatively, light emitting material layers of individual light emitting devices LD may also be independent, so that the light emitting devices LD can directly emit monochromatic light, and light emitting colors of different light emitting devices LD may be different, thereby achieving the color display.

In addition, as shown in FIG. 3, the display panel may further include an encapsulation layer TFE covering individual light emitting devices LD, which may adopt a thin film encapsulation, and may include a first inorganic layer, an organic layer, and a second inorganic layer. The first inorganic layer may cover each light emitting device, that is, the first inorganic layer may cover a surface of the second electrode CAT away from the substrate SU. A material of the first inorganic layer may include an inorganic insulation material such as silicon nitride and silicon oxide. The organic layer may be disposed on a surface of the first inorganic layer away from the substrate Su, and a boundary of the organic layer may be limited to an inner side of the boundary of the first inorganic layer by a blocking dam located in the peripheral area WA, and a material of the organic layer may be an organic material such as resin.

The second inorganic layer may cover the organic layer and the first inorganic layer not covered by the organic layer. The water and oxygen intrusion can be blocked through the second inorganic layer, and planarization is achieved through the organic layer with fluidity (during the manufacturing process). A material of the second inorganic layer may include the inorganic insulation material such as silicon nitride and silicon oxide.

In addition, as shown in FIG. 3, the display panel may further include other film layers such as a touch layer TSP and a transparent cover plate disposed on a side of the encapsulation layer TFE away from the substrate SU, which will not be described in detail herein.

Taking the touch layer TPS adopting a mutual capacitance touch structure as an example, the touch layer TPS may include a plurality of first touch electrodes Tx and a plurality of second touch electrodes Rx. Individual first touch electrodes Tx may be distributed at intervals along the row direction X, a first touch electrode Tx may include a plurality of first electrode blocks Txc distributed at intervals along the column direction Y and a transfer bridge BR coupling two adjacent first electrode blocks Txc. Individual second touch electrode Rx may be distributed at intervals along the column direction Y, a second touch electrode Rx may include a plurality of second electrode blocks Rxc in series along the row direction X, and a transfer bridge BR crosses a second touch electrode Rx and is insulated from the second touch electrode Rx. One of the first touch electrode Tx and the second touch electrode Rx may be used as a transmitting electrode, and the other may be used as a receiving electrode, and both are coupled to a peripheral touch driving circuit.

Furthermore, the touch layer may include a blocking layer TLD, a bridging layer, an isolation layer SEP, a touch electrode layer TMB and a protection layer TOC.

The blocking layer TLD may be disposed on a surface of the encapsulation layer TFE away from the driving backplane BP, and its material may be an insulation material such as silicon nitride and silicon oxide, which is not specifically limited here. The transfer layer may be disposed on a surface of the blocking layer TLD away from the driving backplane BP, and include a plurality of transfer bridges BR distributed in an array. The bridging layer may be made of metal or another conductive material, and include individual transfer bridges BR. The isolation layer SEP may cover the bridging layer, and a material of the isolation layer SEP may be the insulation material such as silicon nitride and silicon oxide, which is not specifically limited here. The touch electrode layer TMB may be disposed on a surface of the isolation layer SEP away from the driving backplane BP, and include the above-mentioned first electrode block Txc and second touch electrode Rx.

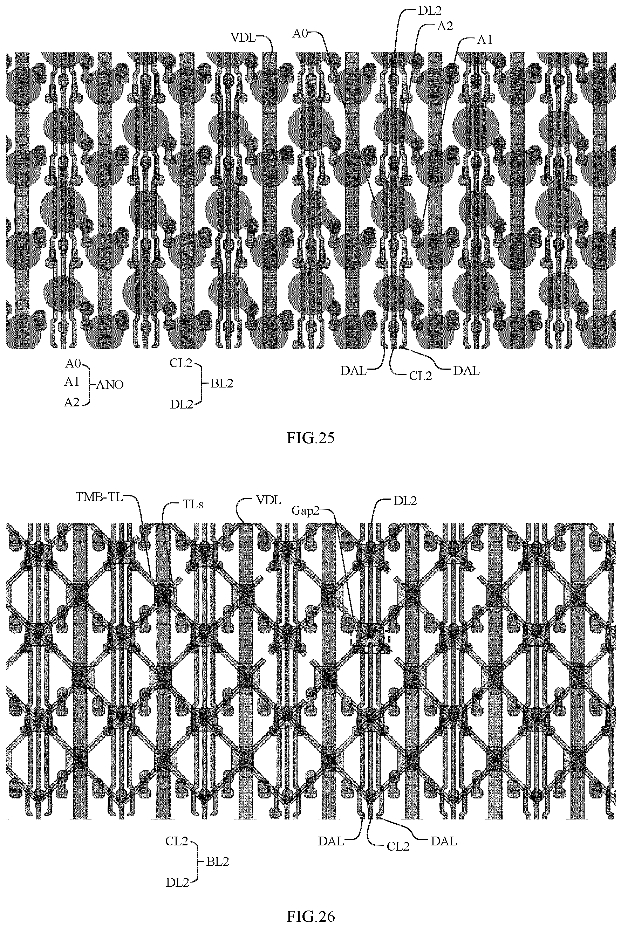

Furthermore, as shown in FIG. 25, a touch electrode layer TMB of the touch layer TSP may adopt a mesh structure with a plurality of meshes to improve light transmittance. Each mesh is surrounded by a plurality of channel lines TL, and one mesh may correspond to one or more light emitting devices LD, that is, orthographic projections of the one or more light emitting devices LD on the substrate SU may be within an orthographic projection of the mesh on the substrate SU to prevent the channel line TL from blocking the light emitting device LD.

As shown in FIG. 3, a driving circuit may be coupled to the light emitting device LD, so that each light emitting device LD can be driven to emit light independently. Specifically, the driving backplane BP may include a substrate SU and a driving circuit located on a side of the substrate SU, and the driving circuit may include a plurality of pixel circuits PC and a peripheral circuit. Individual pixel circuits PC may be located in the display area AA and coupled to the first electrode ANO of the light emitting device LD. Alternatively, a partial area of a part of the pixel circuits PC may be located in the peripheral area WA.

As shown in FIG. 2, the peripheral circuit is located in the peripheral area WA, and the peripheral circuit may include a first power bus VSL and a second power bus BVDL. The second power bus BVDL may be coupled to the first electrode ANO of the light emitting device LD through the pixel circuit PC, and a second power signal VDD is applied to the pixel circuit PC. The first power bus VSL may be coupled to the second electrode CAT of the light emitting device LD, and a first power signal VSS is applied to the second electrode CAT. By controlling the pixel circuit PC, a current passing through the light emitting device LD may be controlled, thereby controlling the brightness of the light emitting device LD. The peripheral circuit may include a gate driving circuit and a light emitting control circuit, etc. Alternatively, it may further include other circuits, and the specific structure of the peripheral circuit is not particularly limited here.

Each pixel circuit PC may include a plurality of transistors and capacitors. Channels of individual transistors may be disposed in the same layer and are all made of a semiconductor material such as polysilicon. The pixel circuit PC may be a pixel circuit such as 3T1C, 7T1C, 8T1C, etc. nTmC means that a pixel circuit PC includes n transistors (indicated by the letter "T") and m capacitors (indicated by the letter "C"). The number of pixel circuits PC may be more than one, which are distributed in an array in multiple rows and columns. A pixel circuit PC may be coupled to one light emitting device LD. Alternatively, the pixel circuit PC may be coupled to a plurality of light emitting devices LD. The one-to-one connection between pixel circuits PC and light emitting devices LD is only taken as an example here for explanation.

A pixel circuit with an 8T1C structure is taken as an example for explanation.

As shown in FIG. 4 to FIG. 11, the transistors of the pixel circuit PC may include a first reset transistor T1, a compensation transistor T2, a driving transistor T3, a writing transistor T4, a first light emitting control transistor T5, a second light emitting control transistor T6, a second reset transistor T7, a third reset transistor T8 and a storage capacitor Cst. Each transistor includes a gate, a first electrode and a second electrode, and the first electrode and the second electrode may be turned on or off by applying a control signal to the gate. The storage capacitor Cst includes a first electrode plate Cst1 and a second electrode plate Cst2.

As shown in FIG. 4, the gate of the first light emitting control transistor T5 is used to input a light emitting control signal EM, the first electrode is used to input the second power signal VDD, and the second electrode is coupled to the first electrode of the driving transistor T3. The gate of the driving transistor T3 is coupled to the first node N1, the second electrode and the first electrode of the second light emitting control transistor T6 are coupled to the second node N2, the second electrode of the second light emitting control transistor T6 is coupled to a first electrode ANO of a light emitting device LD, and the gate of the second light emitting control transistor T6 is used to input the light emitting control signal EM.

The gate of the first reset transistor T1 is used to input a first reset control signal RE1, the first electrode is used to input a first reset signal V I1, and the second electrode is coupled to a first node N1.

The gate of the writing transistor T4 is used to input a first scan signal Gate1, the first electrode is used to input a data signal DA, and the second electrode and the first electrode of the driving transistor T3 and the second electrode of the first light emitting control transistor T5 are coupled to the third node N3.

The gate of the compensation transistor T2 is used to input a second scan signal Gate2, the first electrode is coupled to a second node N2, and the second electrode is coupled to the first node N1.

The gate of the second reset transistor T7 is used to input the second reset control signal RE2, the first electrode is used to input the second reset signal VI2, and the second electrode and the second electrode of the second light emitting control transistor T6 and the first electrode ANO are coupled to the fourth node N4.

The gate of the third reset transistor T8 is used to input the second reset control signal RE2, the first electrode is used to input a third reset signal VI3, and the second electrode is coupled to the third node N3.

The first electrode plate Cst1 of the storage capacitor Cst is used to input the second power signal VDD, and the second electrode plate Cst2 is coupled to the first node N1.

An operating principle of the above pixel circuit is explained below.

In a reset stage t1: the first reset transistor T1 is turned on by the first reset control signal RE1, and the first reset signal VI1 is written to the first node N1. At the same time, the second reset transistor T7 and the third reset transistor T8 are turned on by the second reset control signal RE2, the second reset signal VI2 is written to the fourth node N4, and the third reset signal VI3 is written to the third node N3. Thus, the first electrode and the gate of the driving transistor T3 and the first electrode ANO can be reset.

In a writing stage t2: the writing transistor T4 and the compensation transistor T2 are turned on by the first scan signal Gate1 and the second scan signal Gate2, and the data signal DA is written to the first node N1 through the third node N3 and the second node N2 until the potential reaches Vdata +vth, where Vdata is a voltage of the data signal DA, and Vth is a threshold voltage of the driving transistor T3. The first scan signal Gate1 and the second scan signal Gate2 may be the same signal or two synchronous signals. In addition, the first scan signal Gate1 and the second scan signal Gate2 may be high-frequency signals, which is conducive to reducing the load of a source signal of the driving transistor T3.

In a light emitting stage t3: the first light emitting control transistor T5 and the second light emitting control transistor T6 are turned on by the light emitting control signal EM, the driving transistor T3 is turned on under the action of a voltage Vdata+Vth stored in the storage capacitor Cst and the second power signal VDD, and the light emitting device LD emits light under the action of the second power signal VDD and the first power signal VSS. In this process, the first electrode of the driving transistor T3 serves as the source, and the second electrode of the driving transistor T3 serves as the drain.

An output current of the driving transistor T3 satisfies the following formula:

$$I = (\mu WCox/2L)(Vgs-Vth)^2$$

where, I is the output current of the driving transistor T3; $\mu$ is the carrier mobility; Cox is the gate capacitance per unit area, W is a channel width of the driving transistor T3, L is a channel length of the driving transistor T3, Vgs is a gate-source voltage difference (a voltage difference between the gate and the source) of the driving transistor T3, and Vth is a threshold voltage of the driving transistor T3.

According to the above formula for the output current of the driving transistor T3, the gate voltage Vdata+Vth and the source voltage VDD of the driving transistor T3 in the pixel circuit of the present disclosure are substituted into the above formula to obtain: the output current I of the driving transistor T3 = $(\mu WCox/2L)(Vdata+Vth-VDD-Vth)^2$. It can be seen that the output current of the pixel circuit is not related to the threshold voltage Vth of the driving transistor T3, but only related to the Vdata, thereby eliminating the influence of the threshold voltage of the driving transistor T3 on its output current, and the output current can be controlled only through the voltage Vdata of the data signal DA, so as to control the brightness of the light emitting device LD.

It should be noted that the third reset transistor T8 and the first reset transistor T1 can be turned on and off synchronously, that is, the third reset signal VI3 and the first reset signal VI1 can be input synchronously, so that in the reset stage t1, the gate and the first electrode of the driving transistor T3 can be reset by the first reset signal VI1 and the third reset signal VI3, that is, the gate-source voltage difference of the driving transistor T3 is reset, which is conducive to reducing the influence of the hysteresis effect of the driving transistor T3 on the current of the driving transistor T3, thereby improving the afterimage phenomenon. Alternatively, the third reset signal VI3 and the first reset signal VI1 may also be input asynchronously, but the reset should be completed before the writing stage t2.

Each transistor of the above-mentioned pixel circuit may adopt a polycrystalline silicon transistor, that is, the channel of the transistor is polycrystalline silicon, such as a P-type low-temperature polycrystalline silicon transistor or an N-type low-temperature polycrystalline silicon transistor. Alternatively, a metal oxide transistor may also be adopted, that is, the channel of the transistor is a metal oxide such as indium gallium zinc oxide. The P-type low-temperature polycrystalline silicon transistor can be turned off when a high level is input to its gate, and can be turned on when a low level signal is input. The N-type low-temperature polycrystalline silicon transistor can be turned off when a low level is input to its gate, and can be turned on when a high level signal is input. The metal oxide transistor may be an N-type metal oxide transistor, which can be turned on when a high level is input to the gate, and can be turned off when a low level is input.

In some embodiments of the present disclosure, the above-mentioned 8T1C pixel circuit may adopt LTPO (LTPS+Oxide) technologies. Specifically, the driving transistor T3, the writing transistor T4, the second reset transistor T7, the third reset transistor T8, the first light emitting control transistor T5 and the second light emitting control transistor T6 may adopt P-type low temperature polycrystalline silicon transistors; the first reset transistor T1 and the compensation transistor T2 may adopt N-type metal oxide transistors. Since the P-type low temperature polycrystalline silicon transistor has a high carrier mobility, it is conducive to realizing a display panel with high resolution, high response speed, high pixel density and high aperture ratio, so as to obtain a higher carrier mobility and improve the response speed. In addition, the leakage can be reduced by the N-type metal oxide transistor.

The above-mentioned signals input to the pixel circuit may be transmitted through traces. The traces for transmitting the respective signals mentioned above are described below.

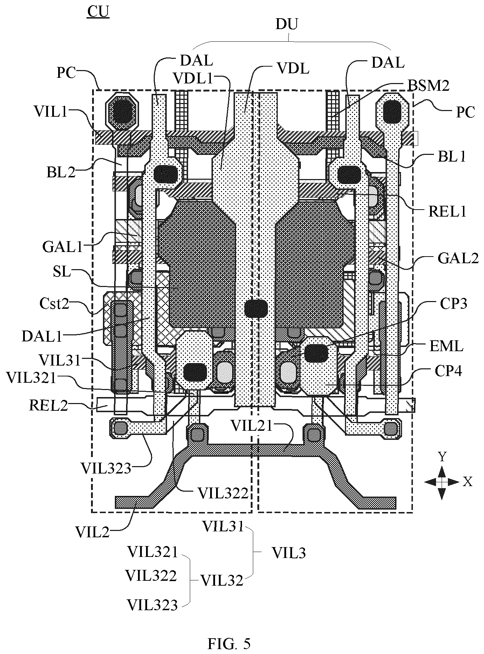

As shown in FIGS. 5 to 11, the driving backplane BP may include a plurality of traces extending at least partially along the row direction X, any of which may be coupled to a row of pixel circuits, and these traces may include a first reset control line REL1, a first reset signal line VIL1, a second reset control line REL2, a second reset signal line VIL2, a third reset signal line VIL3, a first scan line GAL1, a second scan line GAL2 and a light emitting control line EML.

For a pixel circuit PC:

the first reset control line REL1 may be coupled to the gate of the first reset transistor T1 to transmit the first reset control signal RE1. The first reset signal line VIL1 may be coupled to the first electrode of the first reset transistor T1 to transmit the first reset signal VI1.

The second reset control line REL2 may be coupled to the gate of the second reset transistor T7 and the gate of the third reset transistor T8, and is used to transmit the second reset control signal RE2. The second reset signal line VIL2 is coupled to the first electrode of the second reset transistor T7, and is used to transmit the second reset signal VI2. The third reset signal line VIL3 may be coupled to the first electrode of the third reset transistor T8, and is used to transmit the third reset signal VI3.

The first scan line GAL1 may be coupled to the gate of the writing transistor T4, and is used to transmit the first scan signal Gate1. The second scan line GAL2 may be coupled to the gate of the compensation transistor T2, and is used to transmit a second scan signal Gate2.

The light emitting control line EML may be coupled to the gate of the first light emitting control transistor T5 and the gate of the second light emitting control transistor T6, and is used to transmit a light emitting control signal.

In addition to the above-mentioned traces, the driving backplane BP further includes column traces extending along the column direction Y, including a data line DAL and a power line VDL. A data line DAL is coupled to first electrodes of writing transistors T4 of individual pixel circuits in a column of pixel circuits, and is used to transmit a data signal DA. A power line VDL may be coupled to second electrode plates Cst2 and first electrodes of first light emitting control transistors T5 of individual pixel circuits in a column of pixel circuits, and is used to transmit a second power signal VDD.

As shown in FIG. 5, in some embodiments of the present disclosure, individual pixel circuits PC of the driving backplane BP may be divided to obtain a plurality of circuit units CU distributed in an array, and one circuit unit CU may include two adjacent pixel circuits PC distributed along the row direction X. Accordingly, one column of circuit units CU may include two adjacent columns of pixel circuits PC distributed along the row direction X. In addition, the two pixel circuits PC of the same circuit unit CU are symmetrically disposed, that is, the two pixel circuits PC of the same circuit unit CU are mirror-imaged about a straight line extending along the column direction Y. Accordingly, data lines DAL and power lines VDL coupled to the two columns of pixel circuits PC of one column of circuit units CU are also symmetrically disposed. In addition, two adjacent circuit units CU in the row direction X may be symmetrically disposed about a straight line extending along the column direction Y, that is, the pixel circuits of the two circuit units CU are symmetrically disposed about this straight line.

It should be pointed out that the two pixel circuits being "symmetrically disposed" may refer to that patterns of two pixel circuits in all the film layers of the driving backplane BP are symmetrical about a straight line; it may also refer to that patterns of the two pixel circuits in some film layers of the driving backplane including the semiconductor layer (e.g., the first semiconductor layer POL and the second semiconductor layer IGL) are symmetrical about a straight line; it may also refer to that patterns of the two pixel circuits in respective film layers of the driving backplane BP are symmetrical on the whole, but local patterns in some film layers may be locally asymmetric due to process or space limitations, etc. Similarly, two data lines DAL being "symmetrically disposed" and two power lines VDL being "symmetrically disposed" are not limited to the complete symmetry of the pattern of the two data lines DAL or the two power lines VDL, but may also refer to that patterns of the two data lines DAL or the two power lines VDL in the film layers of the driving backplane BP are symmetrical on the whole, but are locally asymmetric due to process or space limitations.

As shown in FIG. 5, in some embodiments, the power line VDL coupled to a column of circuit units CU is located between two data lines DAL, and two power lines VDL may be an integrated structure. Alternatively, it can also be considered that two columns of pixel circuits PC of a column of circuit units CU share the same power line VDL. Further, the data lines DAL may be divided into a plurality of line groups DU distributed along the row direction X, each line group DU includes two data lines DAL distributed along the row direction X, and the two data lines DAL of one line group DU are respectively coupled to the two columns of pixel circuits PC of a column of circuit units CU. Respective transistors and capacitors of a column of circuit units CU may be located between the two data lines DAL coupled to the column of circuit units CU.

In addition, as shown in FIG. 2, the second electrode CAT of each light emitting device LD may be coupled to the first power bus VSL in the peripheral area WA, and the first power bus VSL may be coupled to the binding portion PA, so that the first power signal VSS may be input to the second electrode CAT of the light emitting device LD through the first power bus VSL. In addition, the power line VDL may be coupled to the second power bus BVDL of the peripheral area WA, and the second power bus BVDL may be coupled to the binding portion PA, so that the second power signal VDD may be input to each power line VDL through the second power bus BVDL.

Each data line DAL may be coupled to the binding portion PA so as to input the data signal DA to each data line DAL. The data line DAL located in the main display area MA can be defined as a first data line DAL1, which can be extended from the main display area MA to the lead-out area FA and coupled to the binding portion PA. Alternatively, a part of the data line DAL extending to the lead-out area FA and a part of the data line DAL in the main display area MA can form a certain angle so as to converge to the binding portion PA. In addition, the data line DAL located in the secondary display area SA can be defined as a second data line DAL2, which can be directly extended to the lead-out area FA and coupled to the binding portion PA. However, when the second data line DAL2 is extended to the lead-out area FA, it is necessary to make an area of the peripheral area WA located at the corner of the display panel have the sufficient width, so that the width of the peripheral area WA in this area is large, which is not conducive to reducing the peripheral area WA.

As shown in FIG. 2, in order to reduce the width of the peripheral area WA, a transfer line CL may be used to couple the second data line DAL2 to the binding portion PA, and the transfer line CL may be extended from the secondary display area SA to the main display area MA, and then from the main display area MA to the lead-out area FA, and coupled to the binding portion PA, thereby preventing the second data line DAL2 from directly extending to the lead-out area FA. A second data line DAL2 may be coupled to the binding portion PA through at least one transfer line CL, and the transfer line CL may include a first transfer line CL1 and a second transfer line CL2. The first transfer line CL1 can extend from the secondary display area SA to the main display area MA along the row direction X, and the first transfer line CL1 can be coupled to a second data line DAL2. The second transfer line CL2 can be coupled to the first transfer line CL1, and extend from the main display area MA to the lead-out area FA along the column direction Y, and coupled to the binding portion PA, so that the second data line DAL2 can be coupled to the binding portion PA through the first transfer line CL1 and the second transfer line CL2.

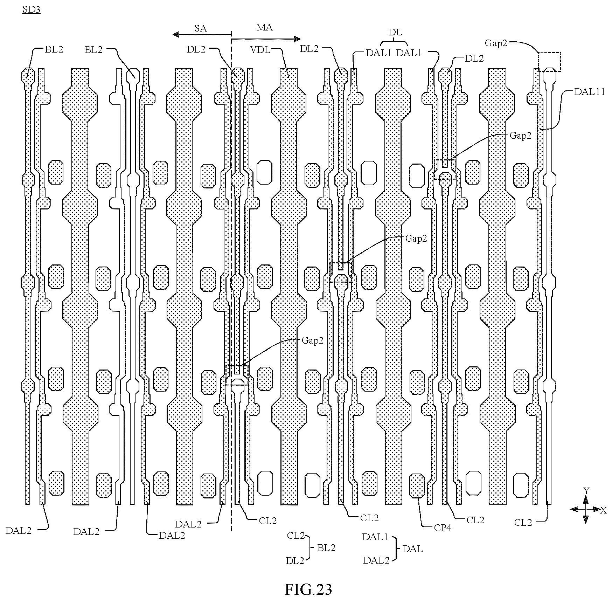

Further, as shown in FIG. 2 and FIG. 21 to FIG. 23, in order to improve the uniformity of a film layer where the transfer line is located, the driving backplane BP may include a plurality of first connection lines BL1 and a plurality of second connection lines BL2.

The first connection lines BL1 may extend along the row direction X and may be distributed at intervals along the column direction Y. At least part of the first connection lines BL1 may include first transfer lines CL1 and first dummy lines DL1 disposed at intervals. For example, the first transfer line CL1 and the first dummy line DL1 adjacent to each other in the same first connection line BL1 are located on the same side and are spaced apart by a gap Gap. One first connection line BL1 may have at most two gaps Gap and one first transfer line CL1 and at least one first dummy line DL1 divided by the gap Gap.

The second connection lines BL2 may extend along the column direction Y and may be distributed at intervals along the row direction X. At least part of the second connection lines BL2 may include second transfer lines CL2 and second dummy lines DL2 disposed at intervals. For example, the second transfer line CL2 and the second dummy line DL2 adjacent to each other in the same second connection line BL2 are located in the same layer and are spaced apart by a gap Gap. One second connection line BL2 may have one gap Gap and one second transfer line CL2 and one second dummy line DL2 divided by the gap Gap. The second transfer line CL2 extends from the main display area MA to the lead-out area FA and is coupled to the binding portion PA.

Individual gaps Gap of individual second connection lines BL2 coupled to individual second data lines DAL2 in the same secondary display area SA may be distributed at intervals along a linear trajectory, and an extension direction of the linear trajectory is intersected with the row direction X and the column direction Y.

It should be noted that some of the first connection lines BL1 may not have gaps, but are continuous lines extending to the peripheral area WA, and are not coupled to the data line DAL, which serves to improve the uniformity of the second source-drain layer SD2. These first connection lines BL1 without the gaps are first dummy lines DL1. In addition, some of the second connection lines BL2 may not have gaps, but are continuous lines extending to the lead-out area FA, and are not coupled to the first transfer line CL1, but may be coupled to the first dummy line DL1 and the first connection line BL1 without the gap, which serves to reduce the uniformity of the voltage drop of the first power signal VSS while improving the uniformity of the third source-drain layer SD3. These second connection lines BL2 without the gaps are second dummy lines DL2.

In the column direction Y, first connection lines BL1 on a side of a first connection line BL1 with a gap away from the lead-out area FA may be all first connection lines BL1 without gaps. In the row direction X, the second connection lines BL2 with the gaps are divided into two parts distributed along the row direction X, one part is coupled to a second data line DAL2 in one secondary display area SA, and the other part is coupled to a second data line DAL2 in the other secondary display area SA, and the two parts can be symmetrically disposed about the central axis of the main display area MA along the column direction Y, and a second connection line BL2 without a gap can exist between the two parts.

The second connection line BL2 and the first connection line BL1 are located in different layers, and thus cross each other in space. In addition, the first connection line BL1 and the data line DAL are located in different layers, and the second connection line BL2 and the data line DAL are insulated, so that any transfer line CL is only coupled to a second data line DAL2, and is not coupled to other second data lines DAL2 and first data lines DAL1. For example, the second connection line BL2 may be located in the same layer as the data line DAL and the power line VDL, and located on a side of the first connection line BL1 away from the substrate SU, and a second connection line BL2 may be located between two adjacent line groups DU, and is spaced apart from two data lines DAL of the line group DU.

Since the first dummy line DL1 and the second dummy line DL2 are spaced from the first transfer line CL1 and the second transfer line CL2, respectively, the first dummy line DL1 and the second dummy line DL2 are not coupled to the data signal DA. Based on this, the inventor proposes that at least part of the first dummy lines DL1 and at least part of the second dummy lines DL2 can be coupled to form a mesh structure, and the mesh structure can be coupled to the first power bus VSL, so as to be coupled to the first power signal VSS, so that there is also a trace for transmitting the first power signal VSS in the display area AA, which can make the voltage drop distribution of the first power signal VSS more uniform, reduce the cross-voltage of the display panel, and thus reduce power consumption.

In addition, in some embodiments of the present disclosure, both the first connection line BL1 and the second connection line BL2 may be disposed in layers, that is, the first transfer line CL1 and the first dummy line DL1 may be located in different layers, so as to separate the first transfer line CL1 and the first dummy line DL1, and the second transfer line CL2 and the second dummy line DL2 may be located in different layers, so as to separate the second transfer line CL2 and the second dummy line DL2. The first transfer line CL1 and the second transfer line CL2 may be located in the same layer or different layers, as long as they can be coupled to form the transfer line CL. The first dummy line DL1 and the second dummy line DL2 may be located in the same layer or different layers, as long as they can be coupled to the first power bus VSL.

The following is an illustrative description of a connection manner of the first connection line BL1 and the second connection line BL2.

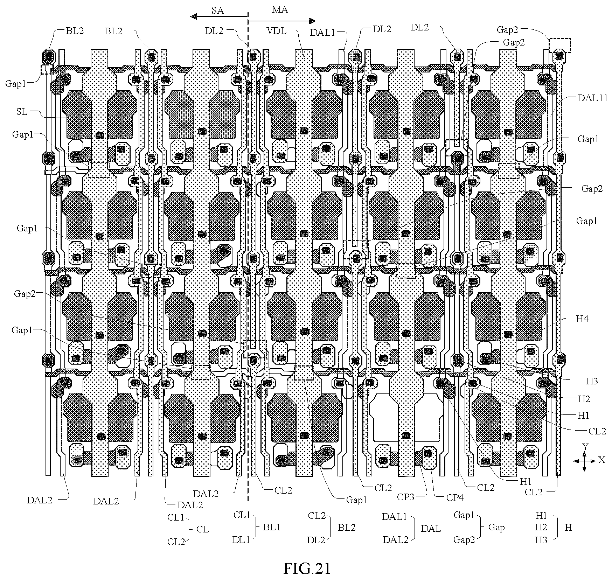

As shown in FIGS. 21 to 23, in some embodiments of the present disclosure, the driving backplane BP further includes first transfer portions CP1 distributed in an array and second transfer portions CP2 distributed in an array, and the first transfer portion CP1, the second transfer portion CP2 and the first connection line BL1 may be disposed in the same layer and may be located on a side of the data line DAL close to the substrate SU. The shapes of the first transfer portion CP1 and the second transfer portion CP2 can be circular, elliptical, polygonal or other regular or irregular shapes.

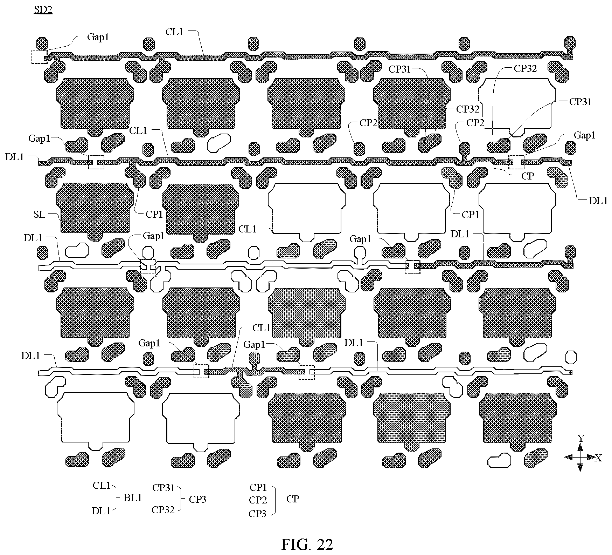

As shown in FIG. 22, the number of first transfer portions CP1 in a column of first transfer portions CP1 may be the same as the number of pixel circuits PC in a column of pixel circuits PC, and a column of first transfer portions CP1 is coupled to first electrodes of respective writing transistors T4 of a column of pixel circuits PC in a one-to-one correspondence. In addition, a column of first transfer portions CP1 may overlap with a data line DAL, and the data line DAL is coupled to respective first transfer portions CP1 overlapping with the data line DAL through contact holes, so that a data line DAL can be coupled to, through the first transfer portions CP1, a column of pixel circuits PC, respectively, so that a data signal DA can be simultaneously input to a column of pixel circuits PC. Since a second data line DAL2 can be coupled to a first transfer line CL1, a first transfer portion CP1 coupled to the second data line DAL2 can be coupled to the first transfer line CL1, so that the first transfer line CL1 and the first transfer portion CP1 are an integrated structure. As such, the second data line DAL2 can be coupled to the first transfer line CL1 through the first transfer portion CP1, and the mutual coupling of the second data line DAL and the first transfer line CL1 can be realized by the coupling of the first transfer portion CP1 to the first transfer line CL1.

A column of second transfer portions CP2 may overlap with a second connection line BL2, and a second transfer line CL2 may be coupled to a first transfer line CP1 as an integral structure, and may be overlapped with and coupled to a second transfer portion CP2, so that the first transfer line CL1 and the second transfer line CL2 may be coupled through the second transfer portion CP2. That is, one transfer line CL may include a first transfer portion CP1 coupled to a second data line DAL2, a first transfer line CL1, a second transfer portion CP2 coupled to the first transfer line CL1 and a second transfer line CL2, and the second transfer line CL2, and the second data line DAL2 may be coupled to the binding portion PA through this path without passing through the corner position of the peripheral area WA.

The mesh structure formed by the first dummy line DL1 and the second dummy line DL2 mentioned above can also be coupled through the second transfer portion CP2. Specifically, at least part of second transfer portions CP2 can be coupled to the first dummy line DL1 as an integral structure, and then at least part of second dummy lines DL2 can be coupled to the second transfer portion CP2 coupled to the first dummy line DL1, so that the first dummy line DL1 and the second dummy line DL2 are coupled through a part of second transfer portions CP2 to form the mesh structure. Alternatively, the second transfer portion CP2 coupling the first dummy line DL1 and the second dummy line DL2 and the second transfer portion CP2 in the transfer line CL are different second transfer portions CP2. In addition, there may be a part of second transfer portions CP2 that is not coupled to the first transfer line CL1 and the first dummy line DL1, and this part of second transfer portions CP2 and the first connection lines BL1 can be disposed at intervals, as long as the formation of the mesh structure that can be coupled to the first power signal VSS and the transfer line CL can be not affected.

As shown in FIGS. 22 to 23, a distribution manner of the first transfer portion CP1 and the second transfer portion CP2 is described in detail below.

As shown in FIG. 22, in some embodiments of the present disclosure, individual first transfer portions CP1 and individual second transfer portions CP2 may be divided into a plurality of transfer groups CP distributed in an array, and a column of transfer groups CP is located between two adjacent line groups DU, and a first connection line BL1 may pass through a row of transfer groups CP. One transfer group CP may include two first transfer portions CP1 and one second transfer portion CP2 distributed in a triangle, where the triangle distribution means that lines connecting centers of the two first transfer portions CP1 and the second transfer portion CP2 are in a triangle form, and the triangle may be an isosceles triangle, etc., which is not specifically limited here. Two second transfer portions CP2 may be symmetrically disposed about a center line between the two adjacent line groups DU which extends along the column direction Y.

For a transfer group CP and a first connection line BL1 passing therethrough, the two first transfer portions CP1 are located on a side of the first connection line BL1 close to the lead-out area FA, and the second transfer portion CP2 is located on a side of the first connection line BL1 away from the lead-out area FA.

Based on the above embodiments, the inventors found that the existence of the gap Gap will affect the uniformity of the picture of the display panel, and therefore proposed a solution to block at least part of gaps Gap. The solution to block the gap Gap is described in detail below.

As shown in FIG. 21, in some embodiments of the present disclosure, the data line DAL and the power line VDL are located on a side of the first connection line BL1 away from the substrate SU, and the data line DAL and the power line VDL can be used to block at least part of the gaps Gap. For example, the gaps Gap can be classified, a gap Gap located at the first connection line BL1 is defined as a first gap Gap1, and a gap Gap located at the second connection line BL2 is defined as a second gap Gap2.

A part of first gaps Gap1 may overlap with the second connection line BL2, thereby being blocked by the second connection line BL2, and part of first gaps Gap1 may overlap with the power line VDL, thereby being blocked by the power line VDL. In addition, if there are two first gaps Gap1 in the same first connection line BL1, the two first gaps Gap1 may be blocked by the second connection line BL2, or blocked by the power line VDL. The second gap Gap2 is in the same layer as the second connection line BL2 and the power line VDL, and is therefore not blocked by the second connection line BL2 and the power line VDL. Alternatively, part of data lines DAL may also overlap with part of first gaps Gap1, thereby using the data line DAL to block the first gap Gap1.

Furthermore, an orthographic projection of a first gap Gap1 on the substrate SU may be located within an orthographic projection on the substrate SU of a power line VDL, a second connection line BL2 or a data line DAL that blocks the first gap Gap1, thereby completely blocking the first gap Gap1.

Furthermore, the second gap Gap2 can be blocked by the first electrode ANO of the light emitting device or by the channel line TL of the touch layer TSP, as illustrated below.

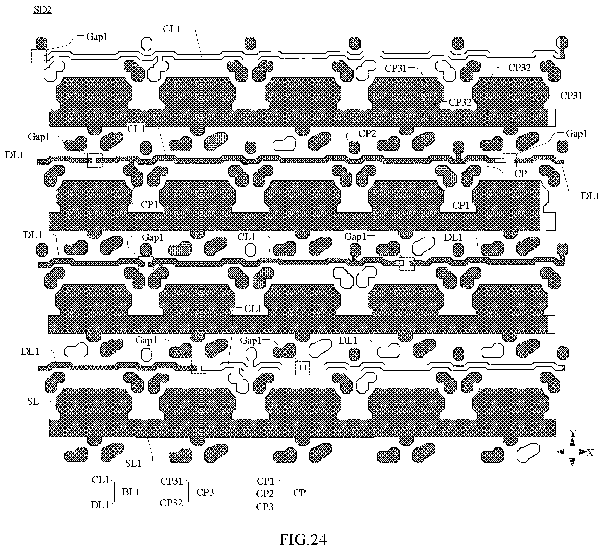

As shown in FIG. 24, in some embodiments of the present disclosure, at least part of second gaps Gap2 may overlap with a part of first electrodes ANO, thereby being blocked by the first electrodes ANO. An orthographic projection of a second gap Gap2 on the substrate SU may be located within an orthographic projection on the substrate SU of a first electrode ANO that blocks the second gap Gap2, thereby completely blocking the second gap Gap2. However, since the distribution manner of first electrodes ANO needs to meet certain pixel arrangement requirements, the structure of the first electrode ANO may be improved, and an extension portion for specifically blocking the second gap Gap2 may be provided.

Specifically, the first electrode ANO may be in a single-layer or multi-layer structure and a light-shielding structure. In addition, the first electrode ANO may include an electrode portion A0 and a first extension portion A1 and a second extension portion A2 extending outward from an edge of the electrode portion A0, that is, the first extension portion A1 and the second extension portion A2 may be radially coupled to the edge of the electrode portion A0. The first extension portion A1 may be coupled to the second electrode of the second light emitting control transistor T6 and the second electrode of the second reset transistor T7 of the pixel circuit through a contact hole, and the second extension portion A2 may overlap with the second gap Gap2, thereby blocking the second gap Gap2 through the second extension portion A2.

As shown in FIG. 25, in some other embodiments of the present disclosure, at least part of gaps Gap may overlap with a part of channel lines TL of the touch electrode layer TMB, for example, the channel lines TL may overlap with at least part of the second gaps Gap2, so that the second gap Gap2 may be blocked by the channel line TL. An orthographic projection of the second gap Gap2 on the substrate SU may be located within an orthographic projection on the substrate SU of the channel line TL blocking the second gap Gap2, thereby completely blocking the second gap Gap2.

For example, an intersection of adjacent channel lines TL can be used to block the second gap Gap2. In order to increase the blocking range, an intersection portion TLs can be formed at the intersection of the channel lines TL, that is, the channel lines TL coupled to each other can converge at the intersection portion TLs, and a width of the intersection portion is greater than a width of the channel line TL, so that an orthographic projection of a second gap Gap2 on the substrate SU is located within an orthographic projection of an intersection portion TLs on the substrate SU.

In other embodiments of the present disclosure, the above-mentioned solutions to block the gap Gap can be combined in ways other than the above-mentioned embodiments. For example, the same gap Gap can be blocked by at least one of the first electrode ANO and the channel line TL in addition to being blocked by one of the second connection line BL2, the data line DAL, and the power line VDL. The first electrode ANO and the channel line TL can block not only the second gap Gap2, but also the first gap Gap1.

As shown in FIGS. 5 to 11, 19 and 22, based on the above-mentioned embodiments, in some embodiments of the present disclosure, the driving backplane BP further includes a plurality of shielding portions SL disposed in the same layer, and the shielding portions SL may be located on a side of the pixel circuit PC away from the substrate SU, and may be located on a side of the data line DAL and the power line VDL close to the substrate SU, and may be disposed in the same layer as the first connection line BL1. In the direction perpendicular to the substrate SU, the shielding portions SL may be disposed one by one with respective pixel circuits PC, and a shielding portion SL overlaps with a channel of a compensation transistor T2 and a first node N1 of a pixel circuit PC, thereby blocking the first node N1 and the channel of the compensation transistor T2. In addition, the shielding portion SL may be coupled to a power line VDL coupled to the pixel circuit PC corresponding to the shielding portion SL, so that the second power signal VDD may be input to the shielding portion SL, so as to shield, by the shielding portion SL, a signal at a side of the first node N1 and the channel of the compensation transistor T2 away from the substrate SU, thereby preventing it from interfering with the signal of the gate of the driving transistor T3 and the compensation transistor T2. Thus, shielding the first node N1 and the compensation transistor T2 by widening the power line VDL can be avoided, thereby reducing the parasitic capacitance between the power line VDL and the data line DAL, which is beneficial to reducing the distance between the data line DAL and the power line VDL, thereby reducing the occupied space and improving the resolution. In addition, the shielding portion SL can also shield the compensation transistor T2 from light, which is beneficial to ensure the stability of the electrical characteristics of the compensation transistor T2.

The following is a detailed description of the film layer of the driving backplane BP using the pixel circuit mentioned above:

As shown in FIGS. 3, 5, and 13 to 20, in addition to the substrate SU, the driving backplane BP may further include a first semiconductor layer POL, a first gate insulation layer GI1, a first gate layer GA1, a first insulation layer ILDO, a second gate layer GA2, a second insulation layer IL1, a second semiconductor layer IGL, a second gate insulation layer GI2, a third gate layer GA3, a third insulation layer IL2, a first source-drain layer SD1, a first planar layer PLN1, a second source-drain layer SD2, a second planar layer PLN2, a third source-drain layer SD3 and a third planar layer PLN3.

The first semiconductor layer POL may be disposed on a side of the substrate SU and include channels of the driving transistor T3, the writing transistor T4, the second reset transistor T7, the third reset transistor T8, the first light emitting control transistor T5 and the second light emitting control transistor T6 in the pixel circuit PC. A material of the first semiconductor layer POL may be polysilicon.

The first gate insulation layer GI1 may cover the first semiconductor layer POL, and a material of the first gate insulation layer GI1 may be an insulation material such as silicon nitride and silicon oxide.

The first gate layer GA1 may be disposed on a surface of the first gate insulation layer GI1 away from the substrate SU, and includes a second reset control line REL2, a light emitting control line EML, a first scan line GAL1 and a first electrode plate Cst1 of a storage capacitor Cst.

The first electrode plate Cst1 overlaps with a part of the first semiconductor layer POL, and the first semiconductor layer POL at the overlap is the channel of the driving transistor T3, and the first electrode plate Cst1 is reused as the gate of the driving transistor T3. The second reset control line REL2 overlaps with a part of the first semiconductor layer POL, and the first semiconductor layer POL at the overlap is the channels of the second reset transistor T7 and the third reset transistor T8, and the second reset control line REL2 at the overlap is the gates of the second reset transistor T7 and the third reset transistor T8. The first scan line GAL1 overlaps with a part of the first semiconductor layer POL, and the first semiconductor layer POL at the overlap is the channel of the writing transistor T4, and the first scan line GAL1 at the overlap is the gate of the writing transistor T4. The light emitting control line EML overlaps a part of the first semiconductor layer POL, and the first semiconductor layer POL at the overlap is the channels of the first light emitting control transistor T5 and the second light emitting control transistor T6, and the light emitting control line EML at the overlap is the gates of the first light emitting control transistor T5 and the second light emitting control transistor T6.

The first insulation layer ILDO may cover the first gate layer GA 1, and a material of the first insulation layer ILDO may be an insulation material such as silicon nitride and silicon oxide.

The second gate layer GA2 may be disposed on a surface of the first insulation layer ILDO away from the substrate SU, and include the second electrode plate Cst2. The second electrode plate Cst2 overlaps with the first electrode plate Cst1, thereby forming the storage capacitor Cst.

The second insulation layer IL1 covers the second gate layer GA2, the second insulation layer IL1 may be in a single layer or a multi-layer structure, and a material of the second insulation layer IL1 may include an inorganic insulation material such as silicon nitride and silicon oxide, or may include an organic insulation material such as insulating resin. For example, the second insulation layer IL1 may include a dielectric layer and a buffer layer stacked in sequence in the direction away from the substrate SU.

The second semiconductor layer IGL may be disposed on a surface of the second insulation layer IL1 away from the substrate SU and include channels of the first reset transistor T1 and the compensation transistor T2. A material of the second semiconductor layer IGL may include a semiconductor metal oxide such as indium gallium zinc oxide (IGZO).

The second gate insulation layer GI2 may cover the second semiconductor layer IGL, and a material of the second gate insulation layer GI2 may be an insulation material such as silicon nitride and silicon oxide.

The third gate layer GA3 may be disposed on a surface of the third gate insulation layer GI3 away from the substrate SU and includes a first reset control line REL1, a first reset signal line VIL1, a second scan line GAL2 and at least part of the third reset signal line VIL3.

The first reset control line REL1 overlaps a part of the second semiconductor layer IGL, the second semiconductor layer IGL at the overlap is the channel of the first reset transistor T1, and the first reset control line REL1 at the overlap is the gate of the first reset transistor T1. The second scan line GAL2 overlaps a part of the second semiconductor layer IGL, the second scan line GAL2 at the overlap is the channel of the compensation transistor T2, and the second scan line GAL2 at the overlap is the gate of the compensation transistor T2.

The third insulation layer IL2 may cover the third gate layer GA3, the third insulation layer IL2 may be in a single layer or a multi-layer structure, and a material of the third insulation layer IL2 may include an inorganic insulation material such as silicon nitride and silicon oxide, or may include an organic insulation material such as insulating resin. For example, the third insulation layer IL2 may include a dielectric layer and a plurality of inorganic insulation layers sequentially stacked in the direction away from the substrate SU.

The first source-drain layer SD1 may be disposed on a surface of the third insulation layer IL2 away from the substrate SU and include the second reset signal line VIL2 and at least part of the third reset signal line VIL3. That is, different areas of the third reset signal line VIL3 may be located at different layers.

The first planar layer PLN1 may be disposed on a side of the first source-drain layer SD1 away from the substrate SU, and a material of the first planar layer PLN1 may be an insulation material such as resin. For example, a passivation layer of the insulation material such as silicon nitride can be used to cover the first source-drain layer SD1, and then the passivation layer can be covered with the first planar layer PLN1.

The second source-drain layer SD2 may be disposed on a surface of the first planar layer PLN1 away from the substrate, and includes a first connection line BL1, a shielding portion SL, a first transfer portion CP1, and a second transfer portion CP2.

The second planar layer PLN2 may cover the second source-drain layer SD2, and a material of the second planar layer PLN2 may be an insulation material such as resin.

The third source-drain layer SD3 may be disposed on a surface of the second planar layer PLN2 away from the substrate SU, and includes a data line DAL, a power line VDL and a second connection line BL2.

The third planar layer PLN3 may cover the third source-drain layer SD3, and a material of the e third planar layer PLN3 may be an insulation material such as resin. The first electrode ANO may be disposed on a surface of the third planar layer PLN3 away from the substrate SU.

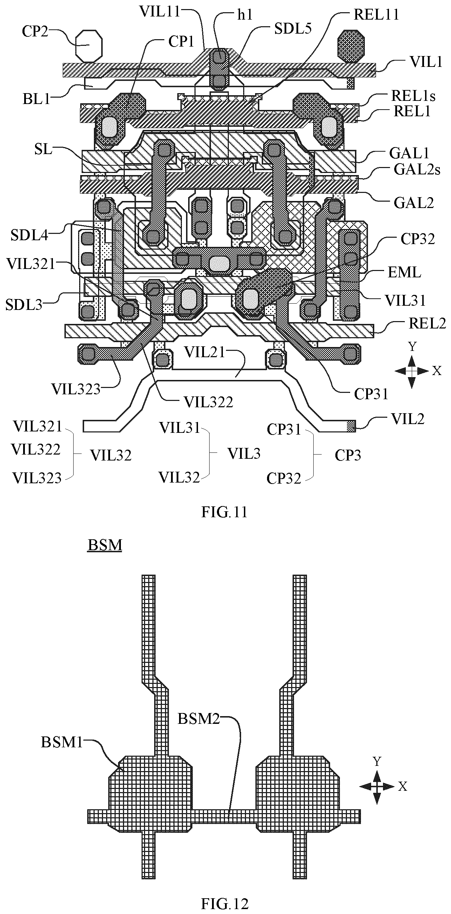

In addition, as shown in FIGS. 5 and 12, a light shielding layer BSM may be disposed between the substrate SU and the first semiconductor layer POL, which may be made of a light shielding metal or another material, and may be in a single-layer or multi-layer structure. At least part of the light shielding layer BSM may overlap with channel areas of at least part of the transistors to shield the light irradiated to the transistors, so that the electrical characteristics of the transistors are stable. For example, the light shielding layer BSM may include a plurality of light shielding units BSM1 distributed in an array, and a light shielding unit BSM1 may shield a channel of a driving transistor T3. In addition, individual light shielding units BSM1 may be coupled by a light shielding line BSM2, so that the light shielding layer BSM is an integrated structure, and the light shielding layer BSM may be coupled to the first power bus VSL or the second power bus BVDL, so as to input the first power signal VSS or the second power signal VDD to the light shielding layer BSM, so that the light shielding layer BSM plays the role of electrostatic shielding.

Further, as shown in FIG. 3, the light shielding layer BSM may be covered by an insulated buffer layer BUF, and the first semiconductor layer POL may be disposed on a surface of the buffer layer BUF away from the substrate SU. The buffer layer BUF may be a single layer or multi-layer structure, and its material may include an insulation material such as silicon nitride and silicon oxide.

In other embodiments of the present disclosure, based on the above-mentioned respective film layers of the driving backplane BP, the first connection line BL1 may also be disposed in the first source-drain layer SD1, and the second connection line BL2 is located in the second source-drain layer SD2. Alternatively, the first connection line BL1 may be located in the third source-drain layer SD3, the second connection line BL2 may be located in the second source-drain layer SD2, and the data line DAL and the power line VDL may be located in the first source-drain layer SD1 or the second source-drain layer SD3. In addition, the first connection line BL1 may also be disposed in the third source-drain layer SD3, and the second connection line BL2 is located in the first source-drain layer SD1 or the second source-drain layer SD2. If the first connection line BL1 and the second connection line BL2 intersect with other traces in the same layer, these traces can be disconnected, and the disconnected parts can be coupled using connection units located in other film layers.

Patterns of individual film layers of the driving backplane BP are described in detail below.

Individual film layers of the pixel circuit PC are taken as an example.

As shown in FIGS. 5 to 11 and 13, the first semiconductor layer POL may include a first active portion ACT1, a second active portion ACT2, a third active portion ACT3, a fourth active portion ACT4 which are as an integrated structure and an independent fifth active portion ACT5.

The first active portion ACT1 may be disposed along the row direction X, the channel T31 of the driving transistor T3 is located in the first active portion ACT1, and a part of the channel T31 may be bent in a direction away from the lead-out area FA along the column direction Y. The channel T31 may be in an "S" or "n" or "l" shape, and the first electrode plate Cst1 overlaps the channel T31, thereby forming the driving transistor T3.

The second active portion ACT2 may extend along the column direction Y, and one end of the second active portion ACT2 may be coupled to one end of the first active portion ACT1, and the other end of the second active portion ACT2 may extend in a direction away from the lead-out area FA. The first scan line GAL1 may intersect the second active portion ACT2 along the row direction X, and the corresponding first active portion ACT1 at the intersection is the channel T41 of the writing transistor T4.

The third active portion ACT3 may extend along the column direction Y, and one end of the third active portion ACT3 may be coupled to one end of the second active portion ACT2 coupled to the first active portion ACT1, and the other end of the third active portion ACT3 may extend in a direction in which the first active portion ACT1 is close to the lead-out area FA. The light emitting control line EML may intersect the third active portion ACT3 along the row direction X, and the corresponding third active portion ACT3 at the intersection is the channel T51 of the first light emitting control transistor T5.

The fourth active portion ACT4 may be disposed along the column direction Y, and one end of the fourth active portion ACT4 is coupled to the first active portion ACT1, and the second active portion ACT2 and the fourth active portion ACT4 are coupled to both ends of the first active portion ACT1. The light emitting control line EML may intersect the fourth active portion ACT4 along the row direction X, and the corresponding fourth active portion ACT4 at the intersection is the channel T61 of the second light emitting control transistor T6. The second reset control line REL2 is located on a side of the light emitting control line EML close to the lead-out area FA, and may intersect the fourth active portion ACT4 along the row direction X, and the corresponding fourth active portion ACT4 at the intersection is the channel T71 of the second reset transistor T7.

The fifth active portion ACT5 and the third active portion ACT3 are distributed along the column direction Y and are located on the side of the first active portion ACT1 close to the lead-out area FA. The second reset control line REL2 can intersect the fifth active portion ACT5 along the row direction X, and the corresponding fifth active portion ACT5 at the intersection is the channel T81 of the third reset transistor T8.

In the first semiconductor layer POL, all regions except the channels of individual transistors are doped regions, and these doped regions are used to form first electrodes and second electrodes of the individual transistors. The specific positions of the first electrode and the second electrode are not particularly limited here, as long as they can be used to realize the connection relationship of the 8T1C pixel circuit mentioned above.

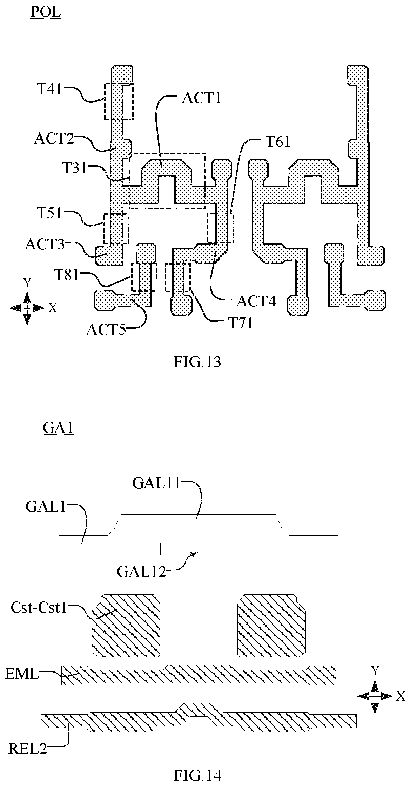

As shown in FIG. 14, a first scan line GAL1, a light emitting control line EML, and a second reset control line REL2 included in the first gate layer GA1 all extend along the row direction X and are distributed along the column direction Y with the first electrode plate Cst1. The first electrode plate Cst1 is located between the first scan line GAL1 and the light emitting control line EML, the first scan line GAL1 is located on a side of the first electrode plate Cst1 away from the lead-out area FA, and the second reset control line REL2 is located on a side of the light emitting control line EML close to the lead-out area FA.

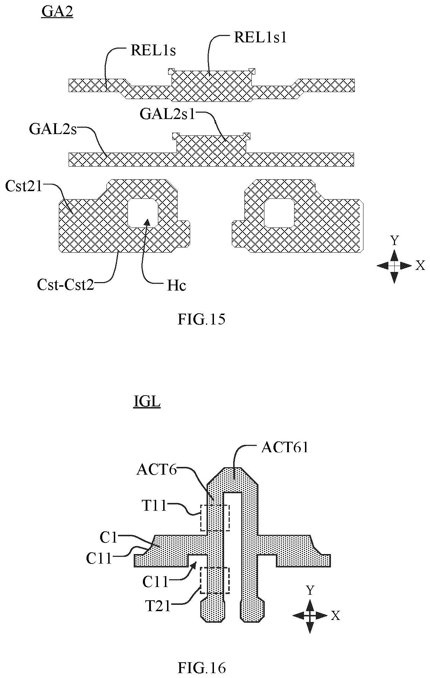

As shown in FIG. 15, the second electrode plate Cst2 of the second gate layer GA2 overlaps with the first electrode plate Cst1 to form the storage capacitor Cst. In some embodiments of the present disclosure, two adjacent circuit units CU in the row direction X are symmetrically disposed, and the second electrode plates Cst2 of the two adjacent circuit units CU are also symmetrically disposed. Two adjacent second electrode plates CsT2 located in the middle among individual second electrode plates Cst2 of the two adjacent circuit units CU can be coupled by a protruding extension Cst21 extending along the row direction X, and the second connection line BL2 and the protruding extension Cst21 can intersect, and can be coupled through a contact hole, thereby being coupled to the two second electrode plates Cst2. The number of contact holes may be one or more. If space permits, providing a plurality of contact holes is conducive to reducing resistance.

As shown in FIG. 16, the second semiconductor layer IGL may include an oxide active portion ACT6 extending along the column direction Y, and the oxide active portion ACT6 is located between the first reset control line REL1 and the third reset signal line VIL3, that is, an orthographic projection of the oxide active portion ACT6 on the substrate SU is located between orthographic projections of the first reset signal line VIL1 and the third reset signal line VIL3 on the substrate SU.

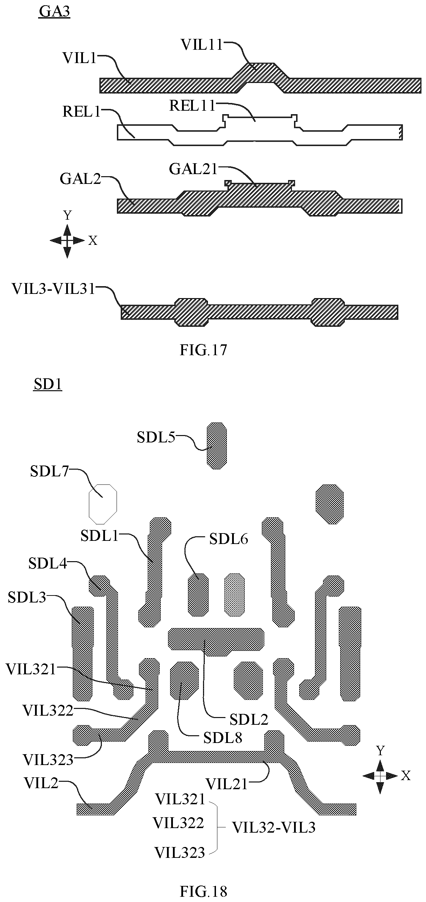

As shown in FIG. 17, the first reset control line REL1 of the third gate layer GA3 may intersect the oxide active portion ACT6 along the row direction X, and the corresponding oxide active portion ACT6 at the intersection is the channel T11 of the first reset transistor T1. The second reset control line REL2 is located on a side of the first reset control line REL1 close to the lead-out area FA, and is distributed at an interval with the first reset control line REL1 along the column direction Y. The second reset control line REL2 may intersect the oxide active portion ACT6 along the row direction X, and the corresponding oxide active portion ACT6 at the intersection is the channel T21 of the compensation transistor T2. The first scan line GAL1 is located between the first reset control line REL1 and the second reset control line REL2, and crosses an area of the oxide active portion ACT6 located between the channel T11 and the channel T21.

As shown in FIG. 16, oxide active portions ACT6 of two pixel circuits PC of the same circuit unit CU are arranged in parallel and are coupled at ends away from the lead-out area FA, so that first electrodes of first reset transistors T1 of the two pixel circuits PC are coupled.

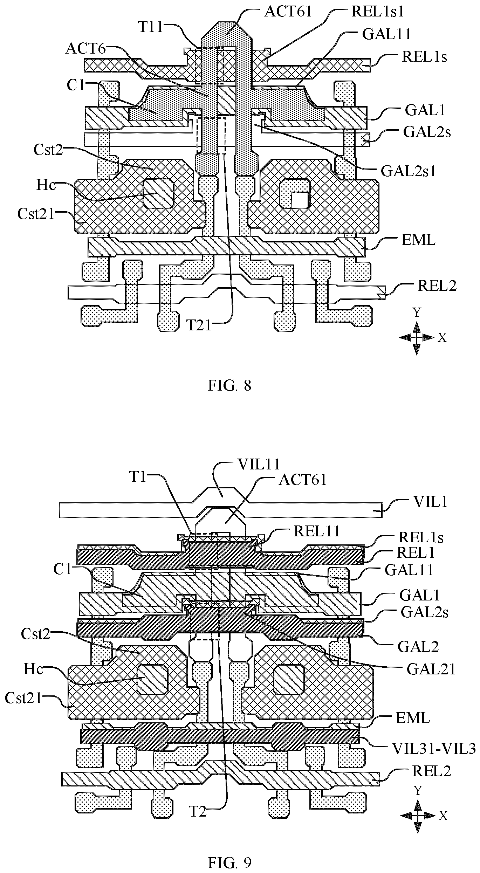

As shown in FIGS. 15 and 9, in some embodiments of the present disclosure, the second gate layer GA2 may further include an auxiliary reset line REL1s and an auxiliary scan line GAL2s extending along the row direction X, and the auxiliary reset line REL1s may overlap with the first reset control line REL1, for example, an orthographic projection of the auxiliary reset line REL1s on the substrate SU is located within an orthographic projection of the first reset control line REL1 on the substrate SU, and extension trajectories of the auxiliary reset line REL1s and the first reset control line REL1 are the same. The first reset control line REL1 also intersects the oxide active portion ACT6, and the corresponding oxide active portion ACT6 at the intersection is still the channel T11 of the first reset transistor T1, and the auxiliary reset line REL1s at the intersection is also the gate of the first reset transistor T1. In addition, the auxiliary reset line REL1s and the first reset control line REL1 may be coupled in the display area AA through a contact hole, or may be coupled after the two are extended to the peripheral area WA, so that an area of the gate of the first reset transistor T1 can be increased.

The auxiliary scan line GAL2s may overlap with the second scan line GAL2, for example, an orthographic projection of the auxiliary scan line GAL2s on the substrate SU is located within an orthographic projection of the second scan line GAL2 on the substrate SU, and extension trajectories of the auxiliary scan line GAL2s and the second scan line GAL2 are the same. The second scan line GAL2 also intersects the oxide active portion ACT6, and the corresponding oxide active portion ACT6 at the intersection is still the channel T21 of the compensation transistor T2, and the auxiliary scan line GAL2s at the intersection is also the gate of the compensation transistor T2. In addition, the auxiliary scan line GAL2s and the second scan line GAL2 may be coupled in the display area AA through a contact hole, or may be coupled after the two are extended to the peripheral area WA, thereby increasing an area of the gate of the compensation transistor T2.

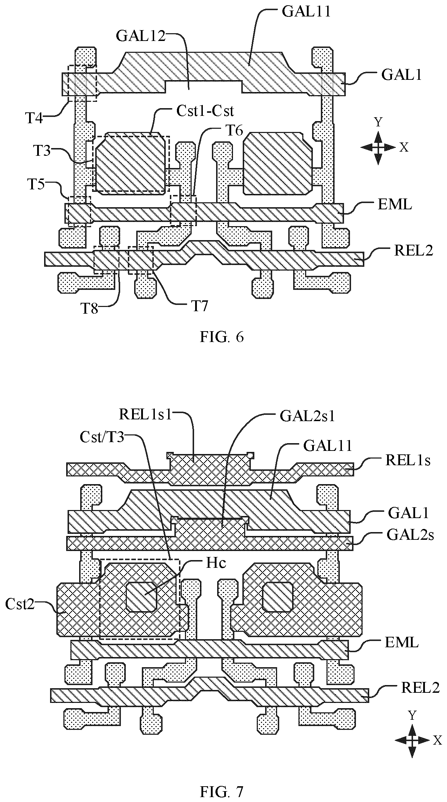

Further, in some embodiments of the present disclosure, as shown in FIG. 7, in order to increase the channel length of the first reset transistor T1, the auxiliary reset line REL1s has a first auxiliary overlapping portion REL1s1 protruding in a direction away from the auxiliary scan line GAL2s along the column direction Y, the first auxiliary overlapping portion REL1s1 overlaps the oxide active portion ACT6, and an area where the first auxiliary overlapping portion REL1s1 overlaps the oxide active portion ACT6 is the gate of the first reset transistor T1. In addition, in order to increase the channel length of the compensation transistor T2, the second auxiliary scan line GAL2s has a second auxiliary overlapping portion GAL2s1 protruding toward the auxiliary reset line REL1s along the column direction Y, the second auxiliary overlapping portion GAL2s1 overlaps the oxide active portion ACT6, and an area where the second auxiliary overlapping portion GAL2s1 overlaps the oxide active portion ACT6 is the gate of the compensation transistor T2.

As shown in FIG. 14, due to the existence of the second auxiliary overlapping portion GAL2s1, the first scan line GAL1 may be provided with a notch GAL12 in order to avoid the second auxiliary scan line GAL2s1, and an orthographic projection of the second auxiliary overlapping portion GAL2s1 on the substrate SU is at least partially located within an orthographic projection of the notch GAL12 on the substrate SU. As shown in FIG. 16, the capacitor portion C1 may also be provided with a notch C11 at a position corresponding to the notch GAL12.

In addition, as shown in FIGS. 9 and 16, a capacitor portion C1 extending along the row direction X is formed in an area of the oxide active portion ACT6 between the channel T11 and the channel T21. The capacitor portion C1 may overlap with the first scan line GAL1, thereby forming a capacitor with the first scan line GAL1. In addition, the capacitor portion C1 may be overlapped with and be coupled to the first node N1. Through the capacitor, the voltage of the data signal DA may be pulled down when the display panel is in a black state to prevent it from exceeding the maximum voltage of a circuit chip in the peripheral circuit or the control circuit board. For a circuit unit CU, capacitor portions C1 of oxide active portions ACT6 of two pixel circuits may extend opposite to each other.

The first reset control line REL1 in the third gate layer GA3 overlaps a part of the oxide active portion ACT6, the oxide active portion ACT6 at the overlap is the channel of the first reset transistor T1, and the first reset control line REL1 at the overlap is the gate of the first reset transistor T1. The second scan line GAL2 overlaps with a part of the oxide active portion ACT6, the second scan line GAL2 at the overlap is the channel of the compensation transistor T2, and the second scan line GAL2 at the overlap is the gate of the compensation transistor T2. The first scan line GAL1 is located between the first reset control line REL1 and the second scan line GAL2, and the first reset signal line VIL1 is located on a side of the first reset control line REL1 away from the second scan line GAL2.

Further, in some embodiments of the present disclosure, as shown in FIGS. 9 and 17, in order to increase the channel length of the first reset transistor T1, the first reset control line REL1 has a first overlapping portion REL11 protruding in a direction away from the second scan line GAL2 along the column direction Y, the first overlapping portion REL11 overlaps with the oxide active portion ACT6, and an area where the first overlapping portion REL11 overlaps with the oxide active portion ACT6 is the gate of the first reset transistor T1. The first overlapping portion REL11 overlaps with the first auxiliary overlapping portion REL1s1, and an orthographic projection of the first overlapping portion REL11 on the substrate SU is located within an orthographic projection of the first auxiliary overlapping portion REL1s1 on the substrate SU. In addition, in order to increase the channel length of the compensation transistor T2, the second scan line GAL2 has a second overlapping portion GAL21 protruding toward the first reset control line REL1 along the column direction Y, the second overlapping portion GAL21 overlaps with the oxide active portion ACT6, and an area where the second overlapping portion GAL21 overlaps with the oxide active portion ACT6 is the gate of the compensation transistor T2. The second overlapping portion GAL21 overlaps with the second auxiliary overlapping portion GAL2s1, and an orthographic projection of the second overlapping portion GAL21 on the substrate SU is located within an orthographic projection of the second auxiliary overlapping portion GAL2s1 on the substrate SU.

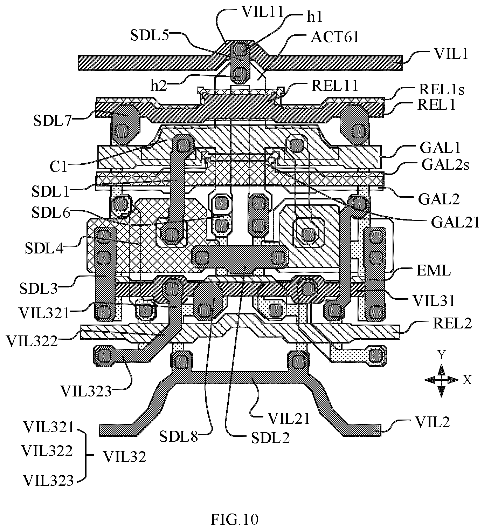

As shown in FIGS. 10 and 18, the first source-drain layer SD1 may include a first connection portion SDL1, a second connection portion SDL2, a third connection portion SDL3, a fourth connection portion SDL4, a fifth connection portion SDL5, a sixth connection portion SDL6, a seventh connection portion SDL7 and a second reset signal line VIL2.

The second connection portion SDL2 may extend along the row direction X, overlap with two second electrode plates Cst2 of two pixel circuits of the same circuit unit CU, and be coupled to the two second electrode plates Cst2 through the contact hole, thereby coupling the two second electrode plates Cst2 of the same circuit unit CU into a conductive whole.

The third connection portion SDL3 may extend along the column direction Y, one end of a third connection portion SDL3 may be coupled to a second electrode plate CsT2 through a contact hole, and the other end may be coupled to, through a contact hole, an area in the third active portion ACT3 for forming the first electrode of the first light emitting control transistor T5.

Furthermore, in some embodiments of the present disclosure, two adjacent circuit units CU in the row direction X are symmetrically disposed, and two adjacent second electrode plates Cst2 in the middle among individual second electrode plates Cst2 of the two adjacent circuit units CU can be coupled by a protruding extension portion Cst21 extending along the row direction X, and the protruding extension portion Cst21 coupling the two second electrode plates Cst2 can be coupled to the same third connection portion SDL3 through a contact hole, so that the first power signal VDD can be transmitted to the two second electrode plates Cst2 at the same time through the same third connection portion SDL3, that is, the pixel circuits PC to which the two second electrode plates Cst2 belong share the same third connection portion SDL3.

Alternatively, in other embodiments of the present disclosure, the above-mentioned protruding extension portion Cst21 may also be disposed to be disconnected, that is, the two second electrode plates Cst2 extend towards each other to form the protruding extension portions Cst21, but the protruding extension portions Cst21 are not directly coupled, and the two protruding extension portions Cst21 are respectively coupled to a third connection portion SDL3 through a contact hole, so that the third connection portion SDL3 is not shared.

The first connection portion SDL1 can extend along the column direction Y and can be located between the second connection portion SDL2 and the third connection portion SDL3. One end of the first connection portion SDL1 overlaps with the capacitor portion C1 and is coupled to the capacitor portion C1 through a contact hole. The other end of the first connection portion SDL1 can overlap with the first electrode plate Cst1 and be coupled to the first electrode plate Cst1 through a contact hole passing through the second electrode plate Cst2. In order to facilitate the coupling between the first connection portion SDL1 and the first electrode plate Cst1, a through hole Hc can be opened on the second electrode plate Cst2, and the contact hole coupling the first connection portion SDL1 and the first electrode plate Cst1 passes through the through hole Hc.

The fourth connection portion SDL4 may extend along the column direction Y and can be located between the third connection portion SDL3 and the first connection portion SDL1. One end of the fourth connection portion SDL4 is coupled to, through a contact hole, an area of the third active portion ACT3 which is used as the second electrode of the writing transistor T4, and the other end is coupled to, through a contact hole, an area of the fifth active portion ACT5 which is used as the second electrode of the third reset transistor T8. In some embodiments of the present disclosure, in the solution in which the pixel circuits PC to which the second electrode plate Cst2 belongs share the same first connection portion SDL1, fourth connection portions SDL4 of the two pixel circuits PC may be symmetrical about the third connection portion SDL3 to save space and facilitate high resolution.

The fifth connection portion SDL5 may extend along the column direction Y, and one end of the fifth connection portion SDL5 is coupled to the first reset signal line VIL1 through the contact hole h1, and the other end of the fifth connection portion SDL5 is coupled to, through a contact hole h2, an area of the oxide active portion ACT6 which is used as the first electrode of the first reset transistor T1. Since ends of the two oxide active portions ACT6 of the same circuit unit CU which are used as the first electrodes of the first reset transistors T1 are coupled, a first reset signal line VIL1 can be coupled to first reset transistors T1 of two pixel circuits of one circuit unit CU through a fifth connection portion SDL5. The fifth connection portion SDL5 may be along a symmetry axis of two pixel circuits of a circuit unit CU, and is a pattern symmetrical about the symmetry axis.

Further, in some embodiments of the present disclosure, two oxide active portions ACT6 of the same circuit unit CU are coupled through an oxide connection portion ACT61, and the oxide connection portion ACT61 may protrude in a direction away from the oxide active portion ACT6 along the column direction Y, so that the contact hole h2 may correspond to the oxide connection portion ACT61, and the contact hole h2 may be prevented from exceeding the boundary of the oxide connection portion ACT61. In addition, an area of the first reset signal line VIL1 which corresponds to the oxide connection portion ACT61 in the column direction Y is bent in a direction away from the oxide connection portion ACT61, forming a bending portion VIL11, and the contact hole h1 is correspondingly coupled to the bending portion VIL11. By providing the bending portion VIL11, while avoiding overlapping with the oxide connection portion ACT61, an area of the first reset signal line VIL1 other than the bending portion VIL11 may be closer to the oxide active portion ACT6 and the first reset control line REL1 in the column direction Y, which is conducive to making the trace and the pixel circuit more compact and saving space. Meanwhile, the bending portion VIL11 can be coupled to the contact hole h1 while avoiding the contact hole h2.

The sixth connection portion SDL6 can extend along the column direction Y and be located on a side of the first connection portion SDL1 away from the fourth connection portion SDL4. One end of the sixth connection portion SDL6 may be coupled to, through a contact hole, an area of the oxide active portion ACT6 which is used as the first electrode of the compensation transistor T2, and the other end may be coupled to, through a contact hole, an area of the first active portion ACT1 which is used as the second electrode of the driving transistor T3.

The seventh connection portion SDL7 may be coupled to, through a contact hole, an area of the second active portion ACT2 which is used as the first electrode of the writing transistor T4. A shape of the seventh connection portion SDL7 may be circular, elliptical, polygonal, or other regular or irregular shapes, which are not particularly limited herein.

Further, in some embodiments of the present disclosure, the capacitor portion C1 may extend toward the contact hole coupling the seventh connection portion SDL7 and the second active portion ACT2, but in order to avoid the contact hole, a contour of an end of the capacitor portion C1 close to the contact hole may be arc-shaped, and does not overlap with the seventh connection portion SDL7, which is conducive to maximizing an area of the capacitor portion C1 without overlapping with the contact hole. Accordingly, in order to match the shape of the first capacitor C1 to form a capacitor, the first scan line GAL1 has a second capacitor portion GAL11 protruding in a direction away from the second scan line GAL2 along the column direction Y, and the second capacitor portion GAL11 overlaps with the capacitor portion C1 to form a capacitor, and an orthographic projection of the capacitor portion C1 on the substrate SU is located within an orthographic projection of the second capacitor portion GAL11 on the substrate SU. A side of the second capacitor portion GAL11 close to the second active portion ACT2 may also be arc-shaped, so as to have the same shape as the capacitor portion C1. Alternatively, the first capacitor C1 may also be in a rectangular shape or another shape, and the second capacitor portion GAL11 has the same shape as the first capacitor C1.

The eighth connection portion SDL8 may be coupled to, through a contact hole, an area of the fourth active portion ACT4 between the channel T61 and the channel T71, thereby being coupled to the second electrode of the second reset transistor T7 and the second electrode of the second light emitting control transistor T6. A shape of the eighth connection portion SDL8 may be circular, elliptical, polygonal, and other regular or irregular shapes, which are not particularly limited herein.

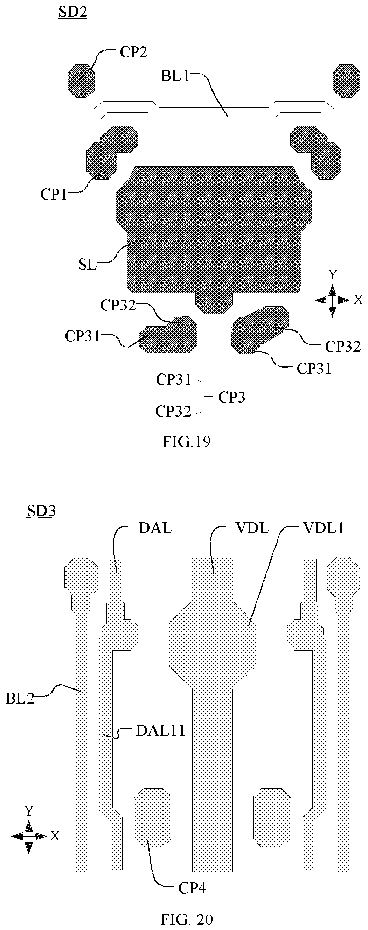

As shown in FIG. 11 and FIG. 19, in the second source-drain layer SD2, the shielding portion SL may overlap with an end (first node N1) of the first connection portion SDL1 coupled to the capacitor portion C1, and overlap with the channel T21 of the compensation transistor T2. Meanwhile, in a circuit unit CU where a shielding portion SL and a first connection portion SDL1 overlapping with the shielding portion SL are located, the shielding portion SL may overlap with the second connection portion SDL2 and be coupled with the second connection portion SDL2 through a contact hole, and the second connection portion SDL2 may be coupled to two second electrode plates Cst2 of the same circuit unit CU through the contact holes, so that the shielding portion SL and the two second electrode plates Cst2 of the circuit unit CU may be coupled into a conductive whole. The first transfer portion CP1 is located between the first connection line BL1 and the shielding portion SL.

In a circuit unit CU where a shielding portion SL and a third connection portion SDL3 overlapping with the shielding portion SL are located, two data lines DAL coupled to the circuit unit CU are located on both sides of the shielding portion SL, and a power line VDL coupled to the circuit unit CU is located between the two data lines DAL and overlaps the shielding portion SL.

The second source-drain layer SD2 may further include a first electrode transfer portion CP3 coupled to the eighth connection portion SDL8, which may be coupled to the first electrode ANO through a second electrode transfer portion CP4 in the third source-drain layer SD3. The first electrode transfer portion CP3 may include a body portion CP31 and a transfer extension portion CP32 coupled to an edge of the body portion CP31, and the transfer extension portion CP32 may extend along a straight line, and its direction may be the row direction X or the column direction Y, or another direction different from the row direction X and the column direction Y. Body portions CP31 of two first electrode transfer portions CP3 coupled to two eighth connection portions SDL8 coupled to two pixel circuits PC of the same pixel unit CU may be along the row direction X, and extension directions of transfer extension portions CP32 of two first electrode transfer portions CP3 may be different. For example, one transfer extension portion CP32 may extend along the row direction X, and the other may form angles less than 90° with the row direction X and the column direction Y. That is to say, the two first electrode transfer portions CP3 may be asymmetrical or symmetrical.

As shown in FIG. 5 and FIG. 20, the data line DAL located in the third source-drain layer SD3 can be coupled to the seventh connection portion SDL7 through the contact hole, so as to connect the data line DAL to the first electrode of the writing transistor T4. In a power line VDL and a circuit unit CU coupled thereto, the power line VDL has a protrusion VDL1 protruding toward both sides along the row direction X, and two protrusions VDL1 overlap with channels T11 of first reset transistors of two pixel circuits PC, respectively, so that the protrusions VDL1 can play the role of shielding and light shielding. The first power bus VSL can be at least partially located in the third source-drain layer SD3, the second power bus BVDL may be located in the lead-out area FA, and between the binding portion PA and the display area AA. The second power bus BVDL can extend along the row direction, the third source-drain layer SD3 is located on a side close to the substrate SU, and can be coupled to, through contact holes, portions of individual power lines VDL extending to the lead-out area FA, and can avoid short circuit with the data line DAL.

In addition, the power line VDL can be coupled to the shielding portion SL through the contact hole, and thus coupled to the first electrode (part of the fifth active portion ACT5) of the first light emitting control transistor T5 through the shielding portion SL, the second connection portion SDL2, the second electrode plate Cst2, and the third connection portion SDL3. The second electrode plate Cst2 is used to transmit the first power signal VDD, and the third connection portion SDL3 only needs to couple the second electrode plate Cst2 to the fifth active portion ACT5, and the third connection portion SDL3 is not used to transmit the first power signal VDD in the row direction X, which is conducive to reducing the width of the third connection portion SDL3 in the row direction X, and the width can be twice the width of the data line DAL, so that the width of the third connection portion SDL3 is minimized while the size requirements of the contact hole is ensured, which is conducive to saving space. In addition, the power line VDL is coupled to two second electrode plates Cst2 of the same circuit unit CU through the shielding portion SL and the second connection portion SDL2, and a network for transmitting the first power signal VDD can be formed, which is conducive to reducing the RC loading.

Further, in some embodiments of the present disclosure, for the data line DAL and the power line VDL coupled to the same circuit unit CU, a data line bending portion DAL11 that bends in a direction away from the power line CDL along the row direction X is provided, and the data line bending portion DAL11 and the capacitor portion C1 are distributed in a straight line along the row direction X to avoid the capacitor portion C1 and avoid overlapping with the capacitor portion C1. In addition, the data line bending portion DAL11 bends in a direction away from the first connection portion SDL1, which is conducive to increasing the distance from the first connection portion SDL1, and can prevent the data signal DA from causing crosstalk to the first node N1 of the pixel circuit PC.

In addition, the third source-drain layer SD3 may further include a second electrode transfer portion CP4 coupled to the first electrode transfer portion CP3 through a contact hole, and the second electrode transfer portion CP4 may be coupled to the first electrode ANO through the contact hole, so as to being coupled to an area of the fourth active portion ACT4 between the channel T71 of the second reset transistor T7 and the channel T61 of the second light emitting control transistor T6 through the second electrode transfer portion CP4, the first electrode transfer portion CP3, and the eighth connection portion SDL8, that is, coupled to the second electrode of the second reset transistor T7 and the second electrode of the second light emitting control transistor T6.

In addition, as shown in FIG. 24, in some embodiments of the present disclosure, adjacent shielding portions SL in the same row of pixel circuits PC may be coupled via a connection segment SL1 to further increase a range of a conductive network that can be coupled to the first power signal VDD, which is beneficial for reducing the RC loading.

The following is a detailed description of a distribution manner of traces coupled to a row of pixel circuits PC.

As shown, the first reset control line REL1, the first reset signal line VIL1, the second reset control line REL2, the second reset signal line VIL2, the third reset signal line VIL3, the first scan line GAL1, the second scan line GAL2 and the light emitting control line EML coupled to the same row of pixel circuits PC all extend along the row direction X and are distributed along the column direction Y.

The first reset control line REL1, the first scan line GAL1, the second scan line GAL2, the third reset signal line VIL3, the light emitting control line EML and the second reset control line REL2 are located between the first reset signal line VIL1 and the second reset signal line VIL2. The first scan line GAL1, the second scan line GAL2, at least part of the third reset signal line VIL3 (a line body VIL31) and the light emitting control line EML are located between the first reset control line REL1 and the second reset control line REL2. The second scan line GAL2 is located between the first scan line GAL1 and the light emitting control line EML. The second electrode plate Cst2 is located between the second scan line GAL2 and the at least part of the third reset signal line VIL3 (the line body VIL31). The light emitting control line EML overlaps with at least part of the third reset signal line VIL3 (a line branch VIL32).

In order to save space and improve resolution, some traces of different film layers can be overlapped.

For example, in some embodiments of the present disclosure, a first reset signal line VIL1 coupled to pixel circuits PC of the n+1th row overlaps with a second reset control line REL2 coupled to the pixel circuits PC of the nth row, and an orthographic projection of the first reset signal line VIL1 on the substrate SU and an orthographic projection of the second reset control line REL2 on the substrate SU at least partially overlap along the row direction X. In addition, a first reset signal line VIL1 overlaps with a first connection line BL1.

In some embodiments of the present disclosure, a second reset signal line VIL2 coupled to pixel circuits PC of the n+1th row overlaps with a first reset control line REL1 and a first scan line GAL1 coupled to pixel circuits PC of the nth row, that is, an orthographic projection of the second reset signal line VIL2 on the substrate SU and orthographic projections of the first reset control line REL1 and the first scan line GAL1 on the substrate SU at least partially overlap along the row direction X.

In some embodiments of the present disclosure, the second reset signal line VIL2 may have a bending portion VIL21 bent along the column direction Y, and a part of a shielding portion SL coupled to the pixel circuits PC of the n+1th row may be located within the bending portion VIL21 of the second reset signal line VIL2 coupled to the pixel circuits PC of the nth row, that is, an orthographic projection of the part of the shielding portion SL on the substrate SU is located within an orthographic projection of the bending portion VIL21 on the substrate SU, so that the shielding portion SL can be avoided through the bending portion VIL21. The fourth active portions ACT4 of the two pixel circuits PC of the same circuit unit CU are both coupled to the bending portion VIL21 of the second reset signal line VIL2 through contact holes.

A structure of the third reset signal line VIL3 is described in detail below.

As shown in FIGS. 9 to 11 and 18, the third reset signal line VIL3 may include a line body VIL31 extending along the row direction X and a line branch VIL32 coupled to a side of the line body VIL31 close to the second reset signal line VIL2. The line body VIL31 and the line branch VIL32 are located in different layers. The line body VIL31 is located between the second scan line GAL2 and the second reset control line REL2, and overlaps with the light emitting control line EM. The line branch VIL32 may extend between the second reset control line REL2 and the second reset signal line VIL2, and is coupled to the first electrode of the third reset transistor T8. The line body VIL31 is located in the third gate layer GA3, and the line branch VIL32 is located in the first source-drain layer SD1.

Further, the line branch VIL32 may include a first segment VIL321, a second segment VIL322 and a third segment VIL323. The first segment VIL321 may extend along the column direction Y, the third segment VIL323 may extend along the row direction X, and the second segment VIL322 forms angles with the first segment VIL321 and the third segment VIL323. The second segment overlaps with the second reset control line REL2, and the third segment VIL323 is located on a side of the second reset control line REL2 away from the first segment VIL321 and the line body VIL31.

One end of the first segment VIL321 is coupled to the line body VIL31 through a contact hole, and the other end is coupled to one end of the second segment VIL322, the other end of the second segment VIL322 is coupled to one end of the third segment VIL323, and the other end of the third segment VIL323 is coupled to a part of the fifth active portion ACT5 through a contact hole, thereby coupling the line body VIL31 to the third reset transistor T3, so as to transmit the third reset signal VI3. The second segment VIL322 forms angles with the first segment VIL321 and the third segment VIL323, which are greater than 90°, so as to avoid the bending portion VIL21 of the second reset signal line VIL2 and the contact hole coupling the fourth connection portion SDL4 and the fifth active portion ACT5. The fifth active portion ACT5 may have an area extending along the row direction X, which serves as the first electrode of the third reset transistor T3, and the third segment VIL323 may overlap with this area. The first segment VIL321 may overlap a part of the fourth active portion ACT4 which forms the second reset transistor T7.

In addition, angles of the second section VIL322 with the first section VIL321 and the third section VIL323 may be the same, which may be 120°, 125°, 130°, 135°, etc., which is not specifically limited here. Alternatively, the angles of the second section VIL322 with the first section VIL321 and the third section VIL323 may also be different.

The following describes the distribution manner of the first transfer portion CP1, the second transfer portion CP2, the first electrode transfer portion CP3, and the second electrode transfer portion CP4.

As shown in FIG. 19, FIG. 21, FIG. 22 and FIG. 25, in addition to the first transfer portion CP1 and the second transfer portion CP2, the transfer group CP may further include two first electrode transfer portions CP3, and the two first electrode transfer portions CP3 respectively belong to two circuit units CU adjacent to each other in the row direction X, but the first transfer portion CP1 is coupled to writing transistors T4 of the pixel circuits PC in the n+1th row. In addition, the first electrode transfer portion CP3 is coupled to second electrodes of second light emitting control transistors T6 and second reset transistors T7 of the pixel circuits PC in the nth row.

Two first electrode transfer portions CP3 may be located on both sides of a second transfer portion CP2, and coupled to two second electrode transfer portions CP4 through third contact holes H3. The first transfer portion CP1 in the transfer group CP may be coupled to the data line DAL through the first contact hole H1, and the second transfer portion CP2 in the transfer group CP may be coupled to the second connection line BL2 (the second transfer line CL2 or the second dummy line DL2) through the second contact hole H2. The two first electrode transfer portions CP3 are asymmetric with respect to the second transfer portion CP2.

Further, as shown in FIG. 21 and FIG. 22, individual first contact hole H1 and individual second contact hole H2 can be divided into a plurality of hole groups H distributed in an array, and a column of hole groups H is located between power lines VDL coupled to two adjacent circuit units CU. It should be noted that since the power lines VDL coupled to the same circuit unit CU are the power lines VDL coupled to the two pixel circuits PC of the circuit unit CU, the power lines VDL coupled to the same circuit unit CU can be regarded as a whole. A column of hole groups H is actually located between the two wholes. Alternatively, if the power lines VDL coupled to the same circuit unit CU are an integrated structure, a column of hole groups H is located between the two power lines VDL. One hole group H includes two first contact holes H1, one second contact hole H2 and two third contact holes H3, and the two first contact holes H1 and the second contact hole H2 can be distributed in a triangle. A first connection line BL1 passes through a row of hole groups H, and divides the two first contact holes H1 to the same side of the first connection line BL1, and divides the two third contact holes H3 and the second contact hole H2 to the other side of the first connection line BL1.

In the same hole group H, the first contact hole H1 is coupled to the pixel circuit in the n+1th row, and the third contact hole H3 is coupled to the pixel circuit in the nth row. Two third contact holes H3 are located on both sides of the second contact hole H2 and are distributed along the column direction Y. A distance between the two third contact holes H3 in the row direction is approximately equal. The two third contact holes H3 and the first contact hole H1 are also distributed in a triangular shape to blur the visual effect, making the first contact hole H1 less obvious, which helps to improve the uniformity of display. In addition, the two first contact holes H1 can be symmetrically disposed with respect to the second contact hole H2.

In addition, as shown in FIG. 21, the power lines VDL coupled to the same circuit unit CU are coupled to, through a fourth contact hole H4, a shielding portion SL overlapping the circuit unit CU, and individual fourth contact holes are distributed in an array. Two fourth contact holes H4 adjacent to each other in the row direction X can be distributed along the column direction Y, so as to further blur the visual effect and help to improve the uniformity of the display. Alternatively, two fourth contact holes H4 adjacent to each other in the row direction X can also be symmetrically disposed about a second contact hole H2 between power lines VDL coupled to the two fourth contact holes H4.

For example, the second contact hole H2 may be located between the first scan line GAL1 and the first reset signal line VIL1; the third contact hole H3 may be located between the light emitting control line EML and the second reset signal line REL2; and the fourth contact hole H4 may be located between the second scan line GAL2 and the light emitting control line EML.

The present disclosure further provides a display device, which may include the display panel in any of the above embodiments. For the specific structure and the beneficial effects of the display device, reference may be made to the embodiments of the display panel above, which will not be described in detail here. The display device of the present disclosure may be a mobile phone, a television, a tablet computer, and may also be used in an electronic device with a display function such as a watch and a bracelet, which will not be listed one by one here.

Other embodiments of the present disclosure will be apparent to those skilled in the art from consideration of the specification and practice of the present disclosure disclosed herein. The present disclosure is intended to cover any variations, uses, or adaptations of the present disclosure, which are in accordance with the general principles of the present disclosure and include common general knowledge or conventional technical means in the art that are not disclosed in the present disclosure. The specification and embodiments are illustrative, and the real scope and spirit of the present disclosure is defined by the appended claims.

## Claims

1. A display panel, comprising a display area and a peripheral area outside the display area, wherein the peripheral area comprises a lead-out area extended in a direction away from the display area, the lead-out area is provided with a binding portion, the display area and the lead-out area are distributed in a column direction, and the display area comprises a main display area and secondary display areas disposed on both sides of the main display area in a row direction;

the display panel comprises a driving backplane and a plurality of light emitting devices disposed on a side of the driving backplane, the driving backplane comprises a substrate and a plurality of circuit units located on a side of the substrate, a circuit unit comprises two pixel circuits distributed along the row direction, and the two pixel circuits of the same circuit unit are symmetrically disposed;

a light emitting device comprises a first electrode, a light emitting layer and a second electrode stacked in a direction away from the driving backplane, wherein a first electrode is coupled to a pixel circuit;

the driving backplane comprises:

a first power bus, disposed in the peripheral area and coupled to the second electrode;
a plurality of data lines, extended along the column direction and divided into a plurality of line groups distributed along the row direction, wherein each of the line groups comprises two data lines distributed along the row direction, two data lines of one line group are respectively coupled to two columns of pixel circuits of one column of circuit units, individual data lines comprises a plurality of first data lines and a plurality of second data lines, the first data lines are extended from the main display area to the lead-out area and are coupled to the binding portion, and the second data lines are located in the secondary display area;

a plurality of power lines, extended from the display area to the lead-out area along the column direction, wherein two columns of pixel circuits of one column of circuit units are coupled to a power line;

a plurality of first connection lines, extended along the row direction, wherein at least part of the first connection lines comprises first transfer lines and first dummy lines disposed at intervals, and the first transfer lines are extended from the secondary display areas to the main display area;

a plurality of second connection lines, extended along the column direction, wherein a second connection line is located between two adjacent line groups, data lines of the two adjacent line groups are symmetrically disposed about the second connection line between the two line groups, at least part of the second connection lines comprises second transfer lines and second dummy lines disposed at intervals, and the second transfer lines are extended from the main display area to the lead-out area and are coupled to the binding portion;

a first transfer line and a second transfer line are coupled to form a transfer line, and a second data line is coupled to the binding portion at least through a transfer line; and the first connection lines are insulated from the data lines, and at least part of the first dummy lines and at least part of the second dummy lines are coupled, and are coupled to the first power bus.

2. The display panel according to claim 1, wherein the first transfer lines and the first dummy lines are disposed in the same layer and on a side of the power lines close to the substrate, and the second transfer lines and the second dummy lines are disposed in the same layer and on a side of the first connection lines away from the substrate;

a first transfer line and a first dummy line adjacent to each other in the same first connection line are disposed at an interval through a gap, and a second transfer line and a second dummy line adjacent to each other in the same second connection line are disposed at an interval through a gap; and
at least part of gaps of the first connection lines is overlapped with the second connection lines or the power lines.

**3.** The display panel according to claim 2, wherein the first connection lines are located on a side of the data lines close to the substrate.

**4.** The display panel according to claim 3, wherein at least part of the gaps is overlapped with a part of first electrodes.

**5.** The display panel according to claim 2, wherein the display panel further comprises:
a touch layer, disposed on a side of the light emitting devices away from the substrate and comprising a touch electrode layer, wherein the touch electrode layer is a mesh structure surrounded by a plurality of channel lines, and at least part of the gaps is overlapped with a part of the channel lines.

**6.** The display panel according to claim 5, wherein a gap of a first connection line is a first gap, and a gap of a second connection line is a second gap;

a part of first gaps is overlapped with the second connection lines, and the other part of the first gaps is overlapped with the power lines; and the second gap is overlapped with the first electrode or a channel line.

**7.** The display panel according to claim 1, wherein a part of the first transfer lines is continuously extended along the row direction to the peripheral area, and a part of the second transfer lines is continuously extended along the column direction to the lead-out area.

**8.** The display panel according to claim 3, wherein the second connection lines are disposed in the same layer as the data lines and the power lines, and are located on a side of the first connection lines away from the substrate;

the driving backplane further comprises first transfer portions distributed in an array and second transfer portions distributed in an array, wherein the first transfer portions, the second transfer portions and the first connection lines are disposed in the same layer;
a column of first transfer portions is overlapped with a data line, the data line is coupled to respective pixel circuits of a column of pixel circuits through respective first transfer portions overlapped with the data line, respectively, and a first transfer line is coupled to a second data line through a first transfer portion; and
a column of second transfer portions is overlapped with a second connection line, and a second transfer line is coupled to a first transfer line through a second transfer portion.

**9.** The display panel according to claim 8, wherein at least part of the second dummy lines is coupled to at least part of the first dummy lines through at least part of the second transfer portions.

**10.** The display panel according to claim 9, wherein a first transfer portion is coupled to a data line through a first contact hole, and a second transfer portion is coupled to a second connection line through a second contact hole;

individual first contact holes and individual second contact holes are divided into a plurality of hole groups distributed in an array, and a column of hole groups is located between power lines coupled to two adjacent circuit units; and
one of the hole groups comprises two of the first contact holes and one of the second contact holes, and the two first contact holes are symmetrically disposed with respect to the second contact hole.

**11.** The display panel according to claim 10, wherein two first contact holes and one second contact hole in the same hole group are distributed in a triangle.

**12.** The display panel according to claim 11, wherein the driving backplane further comprises first electrode transfer portions distributed in an array and second electrode transfer portions distributed in an array, the first electrode transfer portions are disposed in the same layer as the first transfer portions and the second transfer portions, the second electrode transfer portions are located on a side of the first electrode transfer portions away from the substrate, a first electrode transfer portion and a second electrode transfer portion are overlapped and coupled through a third contact hole, the first electrode is coupled to the pixel circuit through the second electrode transfer portion, the third contact hole and the first electrode transfer portion, and the hole group further comprises the third contact hole; and
in the same hole group, the first contact hole is coupled to a pixel circuit in a n+1th row, the third contact hole is coupled to a pixel circuit in a nth row, and two third contact holes are located on both sides of the second contact hole and distributed along the column direction.

**13.** The display panel according to any one of claims 1 to 12, wherein a pixel circuit comprises a driving transistor, a writing transistor, a compensation transistor, a first reset transistor, a second reset transistor, a third reset transistor, a first light emitting control transistor, a second light emitting control transistor and a storage capacitor, the driving backplane further comprises a first reset control line, a first reset signal line, a second reset control line, a second reset signal line, a third reset signal line, a first scan line, a second scan line and a light emitting control line;

a gate of the driving transistor is coupled to a first node, a first electrode of the driving transistor is coupled to a power line through the first light emitting control transistor, and a second electrode of the driving transistor is coupled to a first electrode of a light emitting device through the second light emitting control transistor, and gates of the first light emitting control transistor and the second light emitting control transistor are coupled to the light emitting control line;

a gate of the first reset transistor is coupled to the first reset control line, a first electrode of the first reset transistor is coupled to the first reset signal line, and a second electrode of the first reset transistor is coupled to the first node;

a gate of the writing transistor is coupled to the first scan line, a first electrode of the writing transistor is coupled to a data line, and a second electrode of the writing transistor is coupled to the first electrode of the driving transistor;

a gate of the compensation transistor is coupled to the second scan line, a first electrode of the compensation transistor is coupled to the second electrode of the driving transistor, and a second electrode of the compensation transistor is coupled to the first node;

a gate of the second reset transistor is coupled to the second reset control line, a first electrode of the second reset transistor is coupled to the second reset signal line, and a second electrode of the second reset transistor is coupled to the first electrode;

a gate of the third reset transistor is coupled to the second reset control line, a first electrode of the third reset transistor is coupled to the third reset signal line, and a second electrode of the third reset transistor is coupled to the first electrode of the driving transistor;

a first electrode plate of the storage capacitor is coupled to the power line, and a second electrode plate of the storage capacitor is coupled to the first node; and

the first reset transistor and the compensation transistor are metal oxide transistors, and the driving transistor, the writing transistor, the second reset transistor, the third reset transistor, the first light emitting control transistor and the second light emitting control transistor are polycrystalline silicon transistors

14. The display panel according to claim 13, wherein the driving backplane further comprises:

a first semiconductor layer, disposed on a side of the substrate, and comprising channels of the driving transistor, the writing transistor, the second reset transistor, the third reset transistor, the first light emitting control transistor, and the second light emitting control transistor;

a first gate insulation layer, by which the first semiconductor layer is covered;

a first gate layer, disposed on a surface of the first gate insulation layer away from the substrate and overlapped with at least part of the first semiconductor layer, wherein the first gate layer comprises the second reset control line, the light emitting control line, the first scan line and the first electrode plate;

a first insulation layer, by which the first gate layer is covered;

a second gate layer, disposed on a surface of the first insulation layer away from the substrate, and comprising the second electrode plate overlapped with the first electrode plate;

a second insulation layer, by which the second gate layer is covered;

a second semiconductor layer, disposed on a surface of the second insulation layer away from the substrate, and comprising channels of the first reset transistor and the compensation transistor;

a second gate insulation layer, by which the second semiconductor layer is covered;

a third gate layer, disposed on a surface of the third gate insulation layer away from the substrate and overlapped with at least part of the second semiconductor layer, wherein the third gate layer comprises the first reset control line, the first reset signal line, the second scan line and at least part of the third reset signal line;

a third insulation layer, by which the third gate layer is covered;

a first source-drain layer, disposed on a surface of the third insulation layer away from the substrate, and comprising the second reset signal line and at least a part of the third reset signal line;

a first planar layer, disposed on a side of the first source-drain layer away from the substrate;

a second source-drain layer, disposed on a surface of the first planar layer away from the substrate, and comprising the first connection lines;

a second planar layer, by which the second source-drain layer is covered;

a third source-drain layer, disposed on a surface of the second planar layer away from the substrate and comprising the data lines, the power lines and the second connection lines; and

a third planar layer, by which the third source-drain layer is covered, wherein the first electrode is disposed on a surface of the third planar layer away from the substrate.

15. The display panel according to claim 14, wherein the second semiconductor layer comprises an oxide active portion extended along the column direction, the oxide active portion is located between the first reset signal line and the third reset signal line, the first reset control line is overlapped with the oxide active portion to form the first reset transistor, and the second reset control line is overlapped with the oxide active portion to form the compensation transistor;

the first source-drain layer comprises a first connection portion, an end of the first connection portion is coupled to the first electrode plate, and the other end is coupled to the oxide active portion between channels of the first reset transistor and the second reset control line; and
the driving backplane further comprises a plurality of shielding portions located on the second source-drain layer, and a shielding portion is overlapped with a first connection portion of a pixel circuit and a channel of the compensation transistor, and is coupled to a power line coupled to the pixel circuit.

16. The display panel according to claim 15, wherein in a circuit unit where a shielding portion and a first connection portion overlapped with the shielding portion are located, two second electrode panels of pixel circuits of the circuit unit are overlapped with and coupled to the shielding portion.

17. The display panel according to claim 16, wherein the first source-drain layer comprises a second connection portion and a third connection portion, the second connection portion is coupled to two second electrode plates, and a third connection portion is coupled to a second electrode plate and a first electrode of the first light emitting control transistor.

18. The display panel according to claim 15, wherein in a circuit unit where a shielding portion and a first connection portion overlapped with the shielding portion are located, two data lines coupled to the circuit unit are located on both sides of the shielding portion, and a power line coupled to the circuit unit is located between the two data lines and is overlapped with and coupled to the shielding portion.

19. The display panel according to claim 14, wherein in a power line and a circuit unit coupled to the power line, the power line has a protrusion protruded toward both sides along the row direction, and two protrusions are overlapped with channels of first reset transistors of two pixel circuits, respectively.

20. The display panel according to claim 15, wherein a first reset control line, a first reset signal line, a second reset control line, a second reset signal line, a third reset signal line, a first scan line, a second scan line and a light emitting control line coupled to pixel circuits in the same row are all extended along the row direction and are distributed along the column direction;

the first reset control line, the first scan line, the second scan line, the third reset signal line, the light emitting control line and the second reset control line are located between the first reset signal line and the second reset signal line; the first scan line, the second scan line, at least part of the third reset signal line and the light emitting control line are located between the first reset control line and the second reset control line; the second scan line is located between the first scan line and the light emitting control line; the second electrode plate is located between the second scan line and at least part of the third reset signal line; and the light emitting control line is overlapped with at least part of the third reset signal line; and
a first reset signal line coupled to pixel circuits in a n+1th row is overlapped with a second reset control line coupled to pixel circuits in a n-th row.

21. The display panel according to claim 20, wherein a second reset signal line coupled to the pixel circuits in the n+1th row is overlapped with both a first scan line and a first reset control line coupled to the pixel circuits in the n-th row.

22. The display panel according to claim 20, wherein the third reset signal line comprises a line body extended along the row direction and a line branch coupled to a side of the line body close to the second reset signal line, the line body and the line branch are located in different layers, the line body is located between the second scan line and the second reset control line, and is overlapped with the light emitting control line, and the line branch is extended between the second reset control line and the second reset signal line, and is coupled to the first electrode of the third reset transistor.

23. The display panel according to claim 22, wherein the line body is located in the third gate layer, and the line branch is located in the first source-drain layer.

24. The display panel according to claim 20, wherein a first reset signal line is overlapped with a first connection line.

25. The display panel according to claim 20, wherein the oxide active portion is provided with a capacitor portion extended along the row direction, and the capacitor portion is coupled between the channels of the first reset transistor and the compensation transistor, and the capacitor portion is overlapped with the first scan line and is coupled to the first connection portion.

26. A display device comprising the display panel according to any one of claims 1 to 25.

SA | MA | SA

Y

X

WA

MA

SA

AA

FA

PA

FIG. 1

FIG. 2

FIG. 3

FIG. 4

FIG. 5

EP 4 542 652 A1

FIG. 6

FIG. 7

FIG. 8

FIG. 9

FIG.10

FIG.11

BSM

FIG.12

POL

T41

ACT2

T31

ACT1

T61

T51

ACT3

T81

Y
X

ACT5

T71

ACT4

FIG.13

GA1

GAL11

GAL1

GAL12

Cst-Cst1

EML

Y
X

REL2

FIG.14

EP 4 542 652 A1

GA2

FIG.15

IGL

FIG.16

GA3

FIG.17

SD1

FIG.18

SD2

FIG.19

SD3

FIG. 20

FIG.21

FIG. 22

FIG.23

SD2

FIG.24

FIG.25

FIG.26

FIG. 27

| INTERNATIONAL SEARCH REPORT | International application No. |
|---|---|
| | **PCT/CN2022/108729** |

**A. CLASSIFICATION OF SUBJECT MATTER**

H01L 27/15(2006.01)i; H10K 59/00(2023.01)i

According to International Patent Classification (IPC) or to both national classification and IPC

**B. FIELDS SEARCHED**

Minimum documentation searched (classification system followed by classification symbols)

IPC:H01L,H10K

Documentation searched other than minimum documentation to the extent that such documents are included in the fields searched

Electronic data base consulted during the international search (name of data base and, where practicable, search terms used)

CNTXT; CNABS; ENTXTC; DPWI; ENTXT; CNKI; IEEE: 显示, 数据, 邦定, 电源, 绑定, 虚拟, 连接, data, bonding, display, power, dummy, connect

**C. DOCUMENTS CONSIDERED TO BE RELEVANT**

| Category* | Citation of document, with indication, where appropriate, of the relevant passages | Relevant to claim No. |
|---|---|---|
| A | CN 114784082 A (BOE TECHNOLOGY GROUP CO., LTD. et al.) 22 July 2022 (2022-07-22)<br>entire document | 1-26 |
| A | CN 114628404 A (BOE TECHNOLOGY GROUP CO., LTD. et al.) 14 June 2022 (2022-06-14)<br>entire document | 1-26 |
| A | CN 110718577 A (WUHAN TIANMA MICRO-ELECTRONICS CO., LTD.) 21 January 2020 (2020-01-21)<br>entire document | 1-26 |
| A | WO 2022111116 A1 (BOE TECHNOLOGY GROUP CO., LTD. et al.) 02 June 2022 (2022-06-02)<br>entire document | 1-26 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **23 November 2023** | **23 November 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2022/108729**

| Patent document cited in search report | | | Publication date (day/month/year) | Patent family member(s) | | | Publication date (day/month/year) |
|---|---|---|---|---|---|---|---|
| CN | 114784082 | A | 22 July 2022 | CN | 114784082 | B | 30 September 2022 |
| CN | 114628404 | A | 14 June 2022 | CN | 114628404 | B | 14 February 2023 |
| CN | 110718577 | A | 21 January 2020 | CN | 110718577 | B | 15 November 2022 |
| WO | 2022111116 | A1 | 02 June 2022 | CN | 114566519 | A | 31 May 2022 |
| | | | | US | 2023157102 | A1 | 18 May 2023 |

Form PCT/ISA/210 (patent family annex) (July 2022)